(19) Europäisches Patentamt
European Patent Office
Office européen des brevets

(11) **EP 2 446 069 B1**

(12) **EUROPEAN PATENT SPECIFICATION**

(45) Date of publication and mention
of the grant of the patent:
**08.08.2018 Bulletin 2018/32**

(51) Int Cl.:
***C30B 29/04*** *(2006.01)*     ***C30B 33/02*** *(2006.01)*
***C30B 31/20*** *(2006.01)*

(21) Application number: **10724883.3**

(22) Date of filing: **25.06.2010**

(86) International application number:
**PCT/EP2010/059078**

(87) International publication number:
**WO 2010/149775 (29.12.2010 Gazette 2010/52)**

(54) **METHOD FOR TREATING SINGLE CRYSTAL CVD DIAMOND AND PRODUCT OBTAINED**

VERFAHREN ZUR BEHANDLUNG EINES CVD-EINKRISTALLDIAMANTS UND DARAUS GEWONNENES PRODUKT

PROCÉDÉ POUR TRAITER DU DIAMANT MONOCRISTALLIN OBTENU PAR DÉPÔT EN PHASE VAPEUR, ET PRODUIT AINSI OBTENU

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **26.06.2009 GB 0911075**
**01.10.2009 GB 0917219**
**04.03.2010 GB 201003613**
**01.04.2010 GB 201005573**
**10.05.2010 GB 201007728**

(43) Date of publication of application:
**02.05.2012 Bulletin 2012/18**

(73) Proprietor: **Element Six Technologies Limited Didcot, Oxfordshire OX11 0QR (GB)**

(72) Inventors:
• **KHAN, Rizwan Uddin Ahmad**
**Maidenhead Berkshire SL6 6JW (GB)**
• **GEOGHEGAN, Sarah Louise**
**Ascot Berkshire SL5 8BP (GB)**
• **TWITCHEN , Dianel James**
**Ascot Berkshire SL5 8BP (GB)**
• **PERKINS , Neil**
**ascott Berkshire S15 8BP (GB)**

(74) Representative: **Mitchell, Matthew Benedict David**
**Element Six Limited**
**Group Intellectual Property**
**Global Innovation Centre**
**Harwell Oxford**
**Didcot, Oxfordshire OX11 0QR (GB)**

(56) References cited:
EP-A1- 0 615 954    WO-A1-2007/009037
GB-A- 2 430 194    JP-A- 2 000 385
US-A1- 2010 028 556

• wang: "CVD-Grown pink diamonds" GIA 24 September 2009 (2009-09-24), XP002596581 Retrieved from the Internet: URL:http://www.gia.edu/lab-reports-services/index.html [retrieved on 2010-08-13] cited in the application
• KENNEDY T A ET AL: "Long coherence times at 300 K for nitrogen-vacancy center spins in diamond grown by chemical vapor deposition" APPLIED PHYSICS LETTERS, AIP, AMERICAN INSTITUTE OF PHYSICS, MELVILLE, NY, US LNKD- DOI:10.1063/1.1626791, vol. 83, no. 20, 17 November 2003 (2003-11-17), pages 4190-4192, XP002402358 ISSN: 0003-6951
• WALDERMANN ET AL: "Creating diamond color centers for quantum optical applications" DIAMOND AND RELATED MATERIALS, ELSEVIER SCIENCE PUBLISHERS, AMSTERDAM, NL, vol. 16, no. 11, 18 October 2007 (2007-10-18), pages 1887-1895, XP022303880 ISSN: 0925-9635

**Description**

This invention relates to a method of irradiating and annealing CVD diamond material, particularly to a method of irradiating and annealing CVD diamond material containing single substitutional nitrogen, $N_s^0$. Some methods according to the present invention comprise irradiating and annealing the diamond material to produce fancy pale pink coloured diamonds. Other methods according to the present invention comprise irradiating and annealing the diamond material to produce a diamond material suitable for use in spintronic applications. The invention also provides diamond material per se.

The term "fancy-coloured diamond" is a well-established gem trade classification and is used to refer to unusually coloured diamonds. A useful history and background to the grading of fancy coloured diamond gemstones, including the use of Munsell colour charts is given by King et al, in Gems & Gemology, Vol. 30, No. 4, 1994 (pp.220-242).

Intrinsic diamond material has an indirect band gap of 5.5 eV and is transparent in the visible part of the spectrum. Introducing defects or colour centres, as they will be called hereinafter, which have associated energy levels within the band gap gives the diamond a characteristic colour that is dependent on the type and concentration of the colour centres. This colour can result from either absorption or photoluminescence or some combination of these two. Generally absorption is the dominant factor. One example of a common colour centre present in synthetic diamond material is nitrogen which, when on a substitutional lattice site in the neutral charge state, has an associated energy level 1.7 eV below the conduction band which causes absorption at the blue end of the visible spectrum, which by itself causes the diamond to have a characteristic yellow/brown colour. Such a nitrogen atom when on a substitutional lattice site in the neutral charge state is known as a $N_s^0$ defect, the concentration of which is denoted by $[N_s^0]$.

Examples of fancy coloured synthetic and natural diamonds made by introducing colour centres into the diamond are known in the prior art. For example, EP0615954A and EP0316856A describe irradiation of synthetic diamond material with an electron beam or a neutron beam to form lattice defects (interstitials and vacancies) in the crystal. Thereafter the diamond crystal is annealed in a prescribed temperature range to form colour centres. One colour centre described is a substitutional nitrogen atom adjacent to a vacancy, referred to as an "NV colour centre", which can give the diamond material a desirable fancy colour, such as purple (as described in EP0316856A) or red/pink (as described in EP0615954A). EP0615954A states that it was found necessary to employ an NV centre as the colour centre while reducing its concentration, in order to obtain the red or pink colours. The publication states that absorption by type Ib nitrogen has the action of colouring the rough diamond serving as the base yellow. In order therefore to obtain a pink rather than a red diamond, EP0615954A proposes that the absorption coefficient of type Ib nitrogen at 500 nm should be less than 0.1 cm$^{-1}$. They also suggest that the pink diamond should have an absorption coefficient of an NV centre at an absorption peak of 570 nm that is at least 0.005 cm$^{-1}$ and less than 0.3 cm$^{-1}$. The only method for making pink diamond described in the application prepares a synthetic diamond using a very high pressure apparatus on seed crystals at a pressure of 5.5 GPa and a temperature of 1350°C, i.e. HPHT synthetic diamond. The prepared synthetic diamond comprises at least 3x10$^{16}$ atoms/cm$^3$ and not more than 8x10$^{17}$ atoms/cm$^3$ of type 1b nitrogen, and not more than 5x10$^{17}$ atoms/cm$^3$ of boron. The prepared diamond is then irradiated and annealed under prescribed conditions. The irradiation forms lattice defects in the crystal, and the subsequent anneal causes nitrogen atoms to bond with the lattice defects to form NV colour centres.

Another publication describing the formation of fancy coloured diamonds is "Optical Absorption and Luminescence" by John Walker in "Reports on Progress in Physics", Volume 42, 1979. That publication similarly describes the steps of forming lattice defects in crystals by electron beam irradiation, and if necessary annealing to cause the lattice defects to combine with nitrogen atoms contained in the crystals.

US 2004/0175499 (Twitchen et al) and GB2430194 describe a method starting with a coloured CVD diamond, usually brown, and applying a prescribed heat treatment to produce another and desirable colour in the diamond. The prior art reference notes that the relative strengths of the absorption bands in the visible region of the spectrum of brown single crystal CVD diamond can be altered by annealing, with concurrent changes in the Raman spectrum, and that changes in the absorption spectrum are observed at much lower temperatures than are required to alter the colour of brown natural diamond. Significant colour changes are said to be achieved by annealing at atmospheric pressure in an inert atmosphere at temperatures of 1600°C or less, and gemstones polished from the as-grown CVD diamond can have desirable colours including orange-brown and pinkish brown.

US 2007/0053823 (Viktos Vins) describes a method for producing red diamond starting from a natural brown diamond initially containing 92 ppm nitrogen (A form) and 258 ppm nitrogen (B form) and then applying a HPHT treatment at 2150°C and 7 GPa for 10 minutes to decrease the concentration of A and B nitrogen centres and change the colour of the diamond to greenish yellow. The treated diamond is then irradiated with electrons to create vacancies and annealed at 1100°C for 24 hours, thereby forming 1.5 to 2 ppm [NV] colour centres, and changing the colour to a fancy intense purple red.

Wang reports in http://www.gia.edu/research-resources/news-from-research/index.html - article "treated pink CVD 24$^{th}$ June 2009" on characterization of seven intensely coloured CVD synthetic diamonds (graded as Fancy Intense to Fancy Vivid pink or purplish pink). These diamonds are not pale coloured, and their absorption spectra show strong absorptions from vacancy related defects GR1 and ND1 at 741.1 nm and 393.5 nm respectively.

US 2010/0028556 (Apollo) describes a CVD process in which layers of pink coloured diamonds are formed by doping with nitrogen. In certain embodiments one or more pink layers are modified by annealing or by irradiation such as by electrons. Irradiation is said to create vacancies, which can be moved to nitrogen centres by annealing. It is noted that the colour of a layer may be altered by changing the number of nitrogen vacancy centres.

The spin state of a particle *e.g.* a photon, electron, atomic nucleus, atomic defect, etc, with discrete spin states can be manipulated using a number of methods and the spin state can be detected and/or controllably altered, using an energy source or detector. This technology where it is the spin property of the defect or electron which is used is referred to in this specification as spintronics. An electron, photon, atomic nucleus or atomic defect with discrete spin states is analogous to a "bit" in a traditional computer and is termed a "quantum bit" (or "qubit"). However, due to the quantum nature of the spin states, a qubit can exist in not just one of two spin states, but also in a superposition of these spin states. It is this superposition of spin states which would make it possible for qubit based computers to compute certain problems at a much greater speed than is possible for classical computers, and in cryptography applications enable a sender to know for certain if a message has been delivered to a receiver without an eavesdropper also learning of the message's contents.

A large number of materials and structures have been proposed for use as qubit hosts ranging from quantum dot semiconductors to super-cooled ion traps. The alternatives to date suffer the disadvantage of operation only being possible at cryogenic temperatures or having very short transverse relaxation lifetimes (referred to as "T2" herein). In contrast, the negatively charged nitrogen-vacancy ("NV$^-$") defect in diamond can have a T2 that is sufficiently long for its use in a range of applications at room temperature (about 300 K). The NV$^-$ centre in diamond can be used for qubit and other spintronic applications since it has discrete quantised magnetic spin states. The NV$^-$ centre has been thoroughly characterized using techniques such as electron paramagnetic resonance (EPR), photoluminescence (PL), optical absorption spectroscopy and spectroscopy under uniaxial stress. In diamond the NV centre has been identified in both the neutral and negative charge states ("NV$^0$" and "NV$^-$" respectively). The NV centre in its negative charge state (NV$^-$) has a zero phonon line ("ZPL") at 637 nm compared with 575 nm for an NV centre in the neutral state (NV$^0$).

One problem in producing materials suitable for spintronic applications is preventing the qubits from decohering, or at least lengthening the time a system takes to decohere. Decoherence is commonly understood to be the process by which quantum becomes classical; the process by which the determinism of the macroscopic world arises out of the superpositions and entanglements that describe the quantum one. Decoherence times may be quantified and compared using the transverse relaxation time T2. A long T2 time is desirable in applications such as quantum computing as it allows more time for the operation of an array of quantum gates and thus allows more complex quantum computations to be performed. A long T2 is desirable in spintronic applications such as magnetometry as it relates to improved magnetic field sensitivity.

In certain embodiments, especially for spintronic applications, when incorporated into the material, the T2 value for the NV$^-$ quantum spin defects is as high as possible. In order to achieve this it is desirable to have a material which contains only NV$^-$ spin defects and substantially no others, or at least minimised or reduced other defects.

WO 2007/009037 (Apollo) describes how NV centres in diamond can be created in a controlled manner. In one embodiment a single crystal diamond is formed using a CVD process, and then annealed to remove NV centres. A thin layer of single crystal diamond is then formed with a controlled number of NV centres. The Apollo publication explains that CVD diamond grows under conditions where NV$^-$, NV$^0$ and $N_s^0$ centres are all stable (where NV$^-$ centres have a negative charge, and NV$^0$ centres have no charge), and that the ratios of these states can be varied by the growth conditions, the concentration and by heat treatment after growth. The NV$^-$ centres are said to be introduced to form qubits for use in electronic circuits.

WO 2010/010352 and WO 2010/010344 describe methods of making CVD diamond material of high isotropic purity and high chemical purity suitable for use in spintronic applications. The diamond material is made initially using very low concentrations of nitrogen in the source gas, and then nitrogen is introduced into the diamond material by a post-growth implantation method, to provide the nitrogen for formation of NV$^-$ centres. While this method of introducing NV$^-$ centres through implantation may be beneficial for some applications, for others it is desirable to optimize the formation of NV$^-$ through conversion of nitrogen already in the material to NV$^-$ centres. The invention described herein is tailored towards that goal.

We have discovered that methods comprising irradiating and annealing CVD diamond material comprising single substitutional nitrogen defects results in diamond material with advantageous properties. In particular we have discovered a method which maximises the production of NV centres, while minimizing other undesirable defects. Material made using this method can be used in spintronic and colour related applications, e.g. for fancy pale pink synthetic gemstones or for coloured filter applications.

This method is different from the method described in EP0615954A for making pink diamonds from HPHT synthetic diamonds described, and also different from the methods described in US 2004/0175499 and US 2010/0028556 for making coloured diamonds. We have also found that diamond material made by the method of this invention advantageously combine high densities of NV centres while simultaneously having a low density of other defects. The invention provides a method of fabricating a single crystal CVD diamond and a CVD synthetic single crystal diamond as set out in the appended claims.

A first aspect of the present invention provides a method comprising:

i) providing a single crystal diamond material that has been grown by chemical vapour deposition ("CVD") and contains single substitutional nitrogen ($N_s^0$) and has an absorption spectrum with a total integrated absorption in the visible range from 350 nm to 750 nm such that at least 10% of the integrated absorption is attributable to $N_s^0$;

(ii) irradiating the provided CVD diamond material so as to introduce isolated vacancies V into at least port of the provided diamond material such that the concentration of isolated vacancies in the irradiated diamond material is at least 0.05 ppm and at most 1 ppm; and

(iii) annealing the irradiated diamond material to form NV centres in at least part of the provided CVD diamond material from at least some of the single substitutional nitrogen ($N_s^0$) defects and the introduced isolated vacancies,

wherein the single crystal CVD diamond material thus produced has the following absorption characteristic measured at room temperature:

| Feature | Limit | Experimental Comment |
|---|---|---|
| 3107 cm$^{-1}$ | Absent or $\leq$ 0.1 cm$^{-1}$ | Measured by room temperature FTIR with 1 cm$^{-1}$ wavenumber resolution |

and which has a colour which is graded fancy pale pink when in the form of a 0.5 ct RBC and characterized as follows for an equivalent 0.5 ct RBC:

| Characteristic | Range |
|---|---|
| Hue angle $\alpha$ | 0°-60° |
| C* | 3.0-20 |
| L* | >70 |

The annealing may be carried out at a temperature of at least 700°C and at most 900°C. The anneal may be for a period of at least 0.1 hours.

The CVD diamond material provided in step (i) of the method according to the first aspect of the invention shall be referred to in this specification as "the provided CVD diamond material". The step of actually growing the CVD diamond material may or may not form part of the method of embodiments of the invention. Providing a CVD diamond material may simply mean, for example, selecting a pre-grown CVD diamond material. The diamond material after the irradiation step (ii) shall be referred to in this specification as the irradiated diamond material. The irradiated diamond material after the annealing step (iii) shall be referred to in this specification as the treated diamond material, or as the irradiated and annealed diamond material.

It will be appreciated that the irradiation may be applied to only part of the provided diamond material, or to the whole of the diamond material. For example the penetration of the irradiation may be such that only part of the provided diamond material is irradiated, or part of the provided diamond material may be shielded from irradiation. The treated diamond material, being that part of the provided diamond material that has been both irradiated and annealed may be coterminous with the provided diamond material, or may be only a proportion of it.

The annealing step (iii) of the method shall be referred to in this specification as the "NV-forming" annealing step.

The minimum value of 10% of the integrated absorption that is attributable to single substitution of nitrogen imposes a maximum value of 90% of the integrated absorption that is attributable to other defects in the diamond material. It is those other defects that are thought to be responsible for the brown colouration in diamond material grown by CVD processes incorporating nitrogen in the source gas, and hence the maximum value of 90% of the integrated absorption that is attributable to those other defects limits the brownness of the provided CVD diamond material.

As noted above, EP615954A describes production of pink diamonds starting from HPHT synthetic diamonds. The absorption that is minimised in the EP615954A application is that due to high concentrations of $N_s^0$ which is reduced in order to produce an attractive pink colour. The issue is different for CVD diamond material. For CVD diamond material the issue to be addressed is how much $N_s^0$ is advantageously to be incorporated in to the diamond material and how that can be done, rather than how to reduce the $[N_s^0]$ concentration to low enough levels.

Unlike the HPHT diamond material described in EP0615954A, there are unique features in CVD diamond that has been grown in the presence of nitrogen that usually result in a brown colour being present. These are described in detail later in this specification. Briefly there is a yellow/brown colouration, which has been mentioned earlier, due to the $N_s^0$ defects themselves, and further brown colouration due to other defects in the diamond material that arise during the CVD growth process as a result of the presence of the $N_s^0$ defects. As colour is a combination of the colour of the starting material and the colour introduced from defects formed by post growth treatments, it is desirable for some embodiments of our invention to reduce the brownness in the CVD diamond whilst maintaining sufficient $N_s^0$ that NV centres can be created on irradiation and annealing so as to achieve the desired final pink colour. For other embodiments it is desirable to maintain sufficient $N_s^0$ in the provided diamond so that a sufficient proportion of NV centres relative to unconverted $N_s^0$ defects result in the irradiated and annealed sample, in order to provide advantageous spintronic properties.

Using CVD synthetic diamond material rather than HPHT synthetic diamond material provides not only an alternative means of producing attractive pink diamond material to that described in EP0615954A, but may also be advantageous for a number of reasons. Diamond material produced using HPHT synthesis techniques exhibits strongly differential uptake of nitrogen impurity on the surfaces with different crystallographic orientation (which are the surfaces corresponding to differing growth sectors) that form during synthesis. The diamond material therefore tends to show zones with different colours, resulting from the differing nitrogen impurity concentrations in different growth sectors. In addition, it is hard to control the HPHT diamond material synthesis process sufficiently to give a uniform and desired nitrogen concentration throughout even a single growth sector within the synthesized diamond material. Furthermore, in HPHT diamond material synthesis, it is typical to see impurities resulting from the synthesis process and the catalysts used - examples would be inclusions comprising cobalt or nickel - features that can result in localised and inhomogeneous strain that degrade the mechanical, optical (e.g. clarity grade in a gemstone) and thermal properties. In contrast, CVD diamond material is much more uniform in its properties and will not have any issues with metallic inclusions.

A synthetic CVD diamond material may be unequivocally distinguished from a synthetic diamond material synthesized using HPHT techniques by the dislocation structure. In synthetic CVD diamond, dislocations generally thread in a direction that is roughly perpendicular to the initial growth surface of the substrate, *i.e.* where the substrate is a (001) substrate, the dislocations are approximately aligned parallel to the [001] direction. In synthetic diamond material synthesized using HPHT techniques dislocations that nucleate on surface of the seed crystal (often a surface close to {001}) typically grow in <110> directions. Thus the two types of material can be distinguished by their different dislocation structures observed, for example, in an X-ray topograph.

Another method by which a synthetic CVD diamond material may be positively distinguished from a synthetic diamond material synthesized using HPHT techniques is by detecting the presence of metallic inclusions, such inclusions being incorporated into HPHT-synthesized material as a result of the synthesis process, the metallic inclusions originating from metals used as the solvent catalyst metal, e.g. iron, cobalt, or nickel etc. These inclusions can vary in size, typically from less than 1 $\mu$m to more than 100 $\mu$m. Larger inclusions within that size range may be observed using a stereomicroscope (*e.g.* a Zeiss DV4); whilst smaller inclusions within that size range may be observed using transmitted light in a metallurgical microscope (*e.g.* a Zeiss "Axiophot").

A further method that can be used to provide positive distinction between synthetic diamonds produced by CVD and HPHT methods is photoluminescence spectroscopy (PL). In the case of HPHT-synthesised material, defects containing atoms from the catalyst metals (typically transition metals) used in the synthesis process (*e.g.* nickel, cobalt, or iron etc.) are frequently present and the detection of such defects by PL positively indicates that the material has been synthesised by an HPHT method.

The absence of defects related to the presence of catalyst metal atoms in the diamond material of the provided CVD diamond material in the method of the present invention is an advantage compared with diamond material produced by HPHT methods as such metallic defects can affect the optical properties and local strain around the NV defects leading to altered optical and/or altered spintronic properties.

When considering the influence of the irradiation and annealing steps of the method of the present invention on the colour of the treated diamond material, it is relevant to discuss the background to what is known about the CVD diamonds and their colour.

It is known that the presence of the low concentrations of nitrogen in a CVD growth environment can affect the nature and concentration of the defects that are incorporated in a CVD synthetic diamond material as the diamond material grows, and that at least some of these defects provide colour centres which contribute to the colour of brown CVD diamond. It is also known that these colour centres that contribute to the brown colouration of CVD diamond grown in the presence of low concentrations of nitrogen are unique to single crystal CVD diamond, or to pieces cut or produced from layers of single crystal CVD diamond. It is furthermore known that the colour centres contributing to brown colouration in CVD diamond are different from those contributing to any brown colouration observed in natural diamond because the defects in the CVD diamond material cause absorption bands in the absorption spectra of the grown CVD diamond material that are not found in the absorption spectra of natural diamond. Evidence for this comes from Raman scattering from non-diamond carbon observable with an infrared excitation source (e.g. 785 nm or 1064 nm) which is not observed for brown natural diamond. Further, it is known that these colour centres in natural diamond material anneal at a different temperature to those in CVD diamond material.

It is believed that some of the colour centres contributing to the brown colouration seen in CVD synthetic diamond grown in processes in which low concentrations of nitrogen are introduced relate to localised disruption of the diamond bonding within the single crystal CVD diamond. The exact nature of the defects is not fully understood, but the use of electron paramagnetic resonance (EPR) and optical absorption spectroscopy techniques have been used to study the nature of the defects and improve our understanding somewhat. The presence of the nitrogen in the grown CVD synthetic diamond material can be evidenced by looking at absorption spectra for the grown CVD diamond material, and analysis of these spectra gives some indication of the relative proportions of different types of defect present. A typical spectrum for grown CVD synthetic diamond material grown with nitrogen added to the synthesis environment shows a peak at about 270 nm, which is generated by the presence of neutral single substitutional nitrogen ($N_s^0$) atoms in the diamond lattice. Additionally peaks have been observed at about 350 nm and approximately 510 nm corresponding to other defects characteristic and unique to CVD synthetic diamond material, and furthermore a so-called "ramp", that is a rising background of the form c x $\lambda^{-3}$ has been observed, where c is a constant and $\lambda$ is the wavelength. While the $N_s^0$ is primarily identifiable by its peak at 270 nm, it also contributes in smaller amounts to the absorption spectrum at higher wavelengths, in particular at wavelengths in the visible part of the spectrum, which is generally considered to cover the wavelength range 350 nm to 750 nm.

The contribution by the $N_s^0$ defect in the visible part of the absorption spectrum affects the colour of any diamond material that the defects are present in, and is believed to be responsible for the yellow colouration of HPHT synthesised type Ib diamond material, which typically comprises 100-250 ppm $N_s^0$.

It is the combination of features evident in the visible part of the absorption spectrum of the CVD diamond material, i.e. (a) the $N_s^0$ contribution in the visible part of the spectrum, (b) the 350 nm peak, (c) the 510 nm peak and (d) the ramp feature, that affect the perceived colour of the diamond material and are believed to be responsible for the brown colour typically seen in nitrogen doped CVD synthetic diamond material. The peaks at 350 nm and at 510 nm are not seen in the absorption spectra of natural diamonds, nor in the absorption spectra of other synthetic diamonds, for example synthetic HPHT diamonds of the type described in EP615954A. For the purposes of this specification, all defects other than the $N_s^0$ defects that contribute to the absorption spectrum in the visible part of the spectrum, which we have discussed above as the 350 nm, 510 nm and ramp features, will be referred to collectively as "X defects". As noted above, at this time the structural nature of these defects at an atomic level is not understood, merely their effect on the grown diamond material's absorption spectra. Without binding the invention in any way, it is thought that the nature of the defects responsible for the brown colouration might be related to the presence of multi-vacancy clusters (each cluster being made up of tens of vacancies e.g. 30 or 40 vacancies or more) that are grown-in under large growth rates, concomitant with the addition of nitrogen to the plasma to a hydrogen / methane ($H_2/CH_4$) source gas. Such clusters are thermally unstable and may be removed to some degree, by high-temperature treatment (i.e. annealing). It is thought that smaller vacancy-related defects, such as a NVH (nitrogen-vacancy-hydrogen) defects that are made up of nitrogen and hydrogen and a missing carbon atom, may be partially responsible for the brown colour and these defects may also be removed by high-temperature treatment.

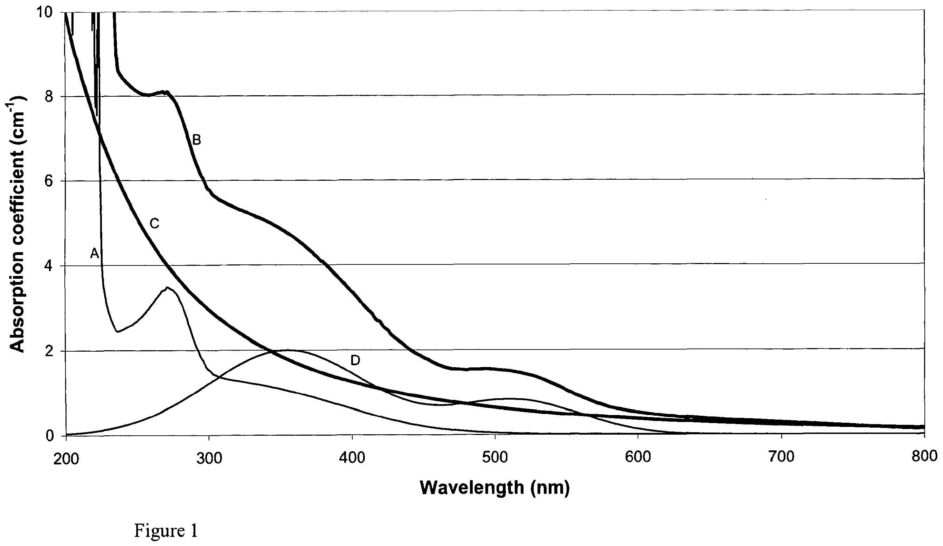

In practice it has been found that the precise width and position in the spectrum of the characteristic absorption bands for the different defects in the CVD diamond material can vary. The position of peak maxima is most easily ascertained by using the second differential of the spectrum. It has been found that absorption spectra can generally be deconstructed into a number of approximate components, and it is useful to carry out this deconstruction, since when the well understood components are subtracted from any recorded spectrum, the contribution of other, less well understood, components can more easily be seen. For example, it is known to subtract the spectral component of standard synthetic diamond material from any observed spectrum. In the present case, for diamond material referred to in the present invention, we have used the spectral decomposition set out in the numbered paragraphs below and shown in Figure 1 (which is a spectral decomposition of the UV/visible absorption spectrum for a brown CVD synthetic diamond material).

1) Single substitutional nitrogen component with an absorption coefficient at 270 nm.

2) An absorption band centred at 3.54 eV (350 nm) $\pm 0.2$ eV with a full width at half maximum (FWHM) of approximately 1 eV.

3) An absorption band centred at 2.43 eV (510 nm) $\pm 0.4$ eV with a FWHM of approximately 1 eV.

4) A small residual wavelength dependent component of the measured absorption coefficient (in $cm^{-1}$) that is found to have a wavelength dependence of the following approximate form: c x (wavelength, $\lambda$, in $\mu m$)$^{-3}$ (ramp factor).

Figure 1 shows the absorption spectrum of a typical CVD synthetic diamond layer (curve B) which has been removed from its growth substrate, and the components into which it can be deconvoluted. The first step in the spectral decomposition is the subtraction of the spectrum of a type Ib high pressure high temperature (HPHT) synthetic diamond material (curve A), scaled so that the residual shows no 270 nm feature. This subtraction is made since HPHT diamond is generally understood to have an absorption spectrum corresponding to substantially pure type Ib diamond with no impurity or defects other than single substitutional nitrogen ($N_s^0$) contributing to the room temperature spectrum. Therefore its subtraction from the grown CVD overall spectrum allows the contributions due to the presence of other defects (the X defects) introduced into the diamond in the CVD process to be more distinguishable. The residual spectrum is then be deconvoluted into a c x $\lambda^{-3}$ component (curve C) and two overlapping bands, one centred at 350 nm and the other centred at 510 nm of the kind described above in numbered paragraphs (2) and (3) above. The two overlapping bands are shown as curve D in Figure 1.

It is known that the form of UV/visible optical absorption spectra of CVD synthetic diamond material grown using a range of different processes can be specified by sums of the components described above, with different weighting factors for the components in different cases.

The colour of a diamond coloured by using post growth colour centre formation methods is the colour of the rough diamond prior to post growth treatment combined with the effect on colour of the one or more colour centres modified or produced during the post growth treatment. In order to obtain the ornamental value desired, and thus achieve a combination of high transparency and desirable colour it has been usual practice, for example as described in application EP0615954 A1, to use diamonds that are initially either colourless or pale yellow. The method described in EP0615954 is therefore not readily applicable to brown single crystal CVD diamond.

As noted above, step (i) of the method according to the invention comprises providing a CVD single crystal diamond material that has been grown by CVD and comprises single substitutional nitrogen ($N_s^0$) and has an absorption spectrum with a total integrated absorption in the visible range from 350 nm to 750 nm such that at least 10% of the integrated absorption is attributable to $N_s^0$.

Also, as noted above, this minimum value of 10% of the integrated absorption that is a attributable to single substitution of nitrogen imposes a maximum value of 90% of the integrated absorption that is attributable to other defects in the diamond material and hence limits the brownness of the provided CVD diamond material.

For all samples used in this specification, integrated absorption values and absorption peak heights quoted in this specification are measured using a UV/visible absorption spectrum of the synthetic CVD diamond material taken at room temperature.

All room temperature absorption spectra mentioned herein were collected using a Perkin Elmer Lambda-19 spectrometer. The data recorded in the spectra ("the measured spectrum") were processed in the following way to give information on the proportion of the measured absorption in the range 350 to 750 nm that could be attributed to $N_s^0$ and the proportion of that measured absorption that can be attributed to other defects.

a. A reflection loss spectrum was created using tabulated refractive index data and standard expressions for the reflection loss for a parallel-sided plate. The refractive index was determined according to Peter's equation [(1923) Z. Phys. 15, 358-368)] and subsequent reflection loss derived using the standard Fresnel equation.

b. The reflection loss spectrum was subtracted from the measured absorbance data and an absorption coefficient spectrum for the sample is created from the resulting spectrum.

c. In order to determine the component of the measured spectrum that was attributable to $N_s^0$, an absorption spectrum for type Ib HPHT synthetic diamond (for which the absorption is attributed solely to $N_s^0$) was scaled until it is substantially removed the 270 nm peak from the measured spectrum when subtracted from it. This scaling allows the concentration of nitrogen to be determined.

d. Using the visible region of the spectrum as stretching from 350 nm (*i.e.* 3.2618 eV) to 750 nm (*i.e.* 1.6527 eV), the integrated absorption in the visible region was determined for the measured sample spectrum and for the component of it attributable to $N_s^0$, and the percentage of the integrated absorption that is attributable to $N_s^0$ defects calculated.

e. In practice reflection losses are generally greater than the theoretical values and this makes it difficult without resorting to wavelength specific calorimetry methods to determine absolute absorption coefficient values. In order to correct for additional losses not directly related to absorption the following routine was used. Towards lower energies it was generally the case that below a particular energy the measured absorption no longer showed significant variation with energy. Absorption coefficient data were shifted so that absorption coefficient was zero at 800 nm.

The provided CVD diamond material used in the method according to the present invention has a total integrated absorption in the range from 350 nm to 750 nm such that at least 10 %, or at least 12%, or at least 14%, or at least 16%, or at least 18%, of the integrated absorption (in eV.cm$^{-1}$) is attributable to $N_s^0$. For certain embodiments of method according to the present invention it is preferred that, for the provided CVD diamond material, the percentage of the total integrated absorption that is attributable to $N_s^0$ in the visible range of the absorption spectrum, is as high as possible, for example at least 20%, or at least 30%, or at least 40%, or at least 50%.

For some embodiments the provided CVD diamond has the following characteristic in its room temperature absorption spectrum (absorption coefficient data is shifted so that absorption coefficient is zero at 800 nm):

Table 1

| Designation | Starts (nm) | Ends (nm) | Peak (nm) | Absorption coefficient at peak. (cm$^{-1}$) |
|---|---|---|---|---|
| 270 nm $N_s^0$ | 220 | 325 | 270 | < 4 |

In addition to peak absorption coefficients measured at room temperature after scaling the spectrum according to the methodology above may have the following characteristics set out in Table 2 in its absorption spectrum:

Table 2

| Designation | Starts (nm) | Ends (nm) | Peak (nm) | Absorption coefficient at peak. (cm$^{-1}$) |
|---|---|---|---|---|
| 350 nm band Part of "X" | 270 | 450 | 350 | < 0.7 |
| 510 nm band Part of "X" | 420 | 640 | 510 | < 0.3 |

The absorption characteristics set out in Tables 1 and 2, particularly the absorption coefficient at 270 nm are, as described previously, a measure of $[N_s^0]$, the starting concentration of $N_s^0$ defects, and are particularly advantageous for methods according to the invention which result in a treated diamond material that is fancy pale pink in colour.

For any given provided CVD diamond material, the irradiation introduces isolated vacancies and the annealing process converts at least some of these to NV centres, and it is the NV centres that are responsible for the desirable colour, and/or spin properties in the treated diamond, which are an advantageous result of the method of the present invention. The so-called "target $[N_s^0]$ concentration" desired to achieve any given desired resultant [NV] concentration can thus be determined working backwards from the desired [NV] concentration. Once the target $[N_s^0]$ concentration is known, in repeat production of the provided CVD diamond material, the concentration of $[N_s^0]$ is preferably controlled to within 50%, more preferably 20% of the target $[N_s^0]$ concentration. Control of the target $[N_s^0]$ concentration is particularly advantageous in methods according to the invention that result in a treated diamond with a fancy pale pink colour.

The concentration of $[N_s^0]$ present in the synthetic CVD diamond material of the present invention may be measured using EPR for levels $<5 \times 10^{15}$ cm$^{-3}$ and using UV visible optical absorption techniques for higher concentrations.

$[N_s^0]$ in the neutral charge state content can be measured by using electron paramagnetic resonance (EPR). Whilst the method is well-known in the art, for completeness it is summarised here. In measurements conducted using EPR, the abundance of a particular paramagnetic defect (*e.g.* the neutral single-substitutional nitrogen defect) is proportional to the integrated intensity of all the EPR absorption resonance lines originating from that centre. This permits the concentration of the defect to be determined by comparing the integrated intensity to that which is observed from a reference sample, provided care is taken to prevent or correct for the effects of microwave power saturation. Since continuous wave EPR spectra are recorded using field modulation, double integration is required to determine the EPR intensity and hence the defect concentration. To minimise the errors associated with double integration, base line correction, finite limits of integration, etc., especially in cases where overlapping EPR spectra are present, a spectral fitting method (using a Nelder-Mead simplex algorithm (J. A. Nelder and R. Mead, The Computer Journal, 7 (1965), 308)) is employed to determine the integrated intensity of the EPR centres present in the sample of interest. This entails fitting the experimental spectra with simulated spectra of the defects present in the sample and determining the integrated intensity of each from the simulation. Experimentally it is observed that neither a Lorentzian nor Gaussian line shape provides a good fit to the experimental EPR spectra, therefore a Tsallis function is used to produce the simulated spectra (D.F. Howarth, J.A. Weil, Z. Zimpel, J. Magn. Res., 161 (2003), 215). Furthermore, in the case of low nitrogen concentrations, it is often necessary to use modulation amplitudes approaching or exceeding the line width of the EPR signals to achieve a good signal/noise ratio (enabling accurate concentration determination within a reasonable time frame). Hence pseudo-modulation is employed, with the Tsallis line shape in order to produce a good fit to the recorded EPR spectra (J.S. Hyde, M. Pasenkiewicz-Gierula, A. Jesmanowicz, W.E. Antholine, Appl. Magn. Reson, 1 (1990), 483). Using this method the concentration in ppm can be determined with a reproducibility of better than $\pm 5\%$.

It should be noted that the minimum [NV] concentration in the treated diamond material that can be used for spintronic applications is lower than the minimum [NV] concentration in the treated diamond material that can be used for fancy pale pink coloured diamonds. The treated diamond material for spintronic applications may be fancy pale pink in colouration or may be colourless, or shades between colourless and fancy pale pink, depending on the number of NV centres present in the treated diamond material (more NV centres leading to a pinker colour).

The technique of UV visible spectroscopy is well known in the art and involves measuring the 270 nm peak of the absorption spectrum of the diamond material.

The provided CVD diamond material used in the method according to the present invention has an absorption spectrum with a total integrated absorption in the visible range from 350 nm to 750 nm such that more than 10% of the integrated absorption would be attributable to $N_s^0$ defects.

Methods of CVD diamond material growth are well established and have been described extensively in the patent and other literature, for example in WO 03/052177. These previously documented methods for growing CVD diamond material are believed to result in a diamond material with an absorption spectrum with a total integrated absorption in the visible range from 350 nm to 750 nm such that less than 10% of the integrated absorption would be attributable to $N_s^0$ defects. In other words the contribution of other defects to the visible part of the spectrum would be greater than 90%. Since these other defects are known to lead to the characteristic brown colouration of CVD diamond containing nitrogen, these known prior art CVD growth processes are not suitable for directly growing the provided CVD diamond material used in the method of the present invention.

According to one method according to the invention the provided CVD diamond material may be grown by a CVD process which results in a CVD diamond material sample comprising the target $[N_s^0]$ concentration and preferably having an absorption spectrum with a total integrated absorption in the visible range from 350 nm to 750 nm such that greater than 10% of the integrated absorption is attributable to $N_s^0$. This embodiment may be achieved by using as the source gas in the CVD process a gas mixture containing carbon, hydrogen, nitrogen and oxygen, rather than the more usual carbon hydrogen and nitrogen. In particular, the provided CVD diamond material in step (i) of the method according to the first aspect of the invention may be grown directly by the process described in GB application GB0922449.4 and US provisional application USSN 61/289,282, the entire disclosures of which are incorporated herein by reference. Specifically the method involves providing a substrate; providing a source gas; dissociating the source gas; and allowing homoepitaxial diamond synthesis on the substrate; wherein the synthesis environment comprises nitrogen at an atomic concentration of from about 0.4 ppm to about 50 ppm; and wherein the source gas comprises: a) an atomic fraction of hydrogen, $H_f$, from about 0.40 to about 0.75; b) an atomic fraction of carbon, Cf, from about 0.15 to about 0.30; c) an atomic fraction of oxygen, Of, from about 0.13 to about 0.40; wherein $H_f + C_f + O_f = 1$; wherein the ratio of atomic fraction of carbon to the atomic fraction of oxygen, Cf:Of, satisfies the ratio of about 0.45:1 < Cf:Of < about 1.25:1; wherein the source gas comprises hydrogen atoms added as hydrogen molecules, $H_2$, at an atomic fraction of the total number of hydrogen, oxygen and carbon atoms present of between 0.05 and 0.40; and wherein the atomic fractions $H_f$, Cf and Of are fractions of the total number of hydrogen, oxygen and carbon atoms present in the source gas. This method of growing CVD diamond material shall be referred to in the specification as the "added oxygen CVD growth process".

Depending on the exact process parameters used (for example substrate temperature, pressure, power, the amount of nitrogen in the source gas), the above added oxygen CVD growth process may result directly in providing a diamond material in which greater than 10% of the integrated absorption in the visible range from 350 nm to 750 nm is attributable to $N_s^0$ defects, or not. In general the added oxygen CVD growth process allows a skilled worker to introduce higher percentages of nitrogen than would be possible with standard CVD processes, while reducing the number of other defects leading to the brown colouration. Thus, the present invention also envisages using the added oxygen CVD growth process to introduce such high concentrations of nitrogen that the number of other defects is also significant and the resultant grown diamond material has less than 10% of the integrated absorption in the visible spectrum from 350 nm to 750 nm attributable to $N_s^0$ defects. Such provided diamond material could then be treated by a subsequent anneal as described hereinafter. Tailoring the added oxygen CVD growth process so as to produce the desired diamond material defect concentration, and consequent absorption spectrum, will be a matter of simple experimentation for the person skilled in the art.

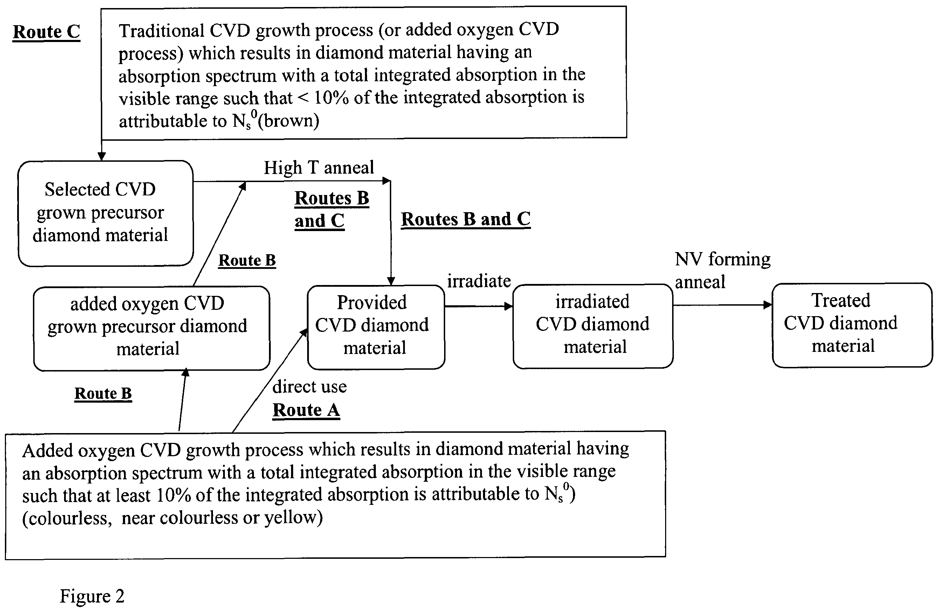

The CVD diamond material grown by the added oxygen CVD growth process, when it results in a provided diamond in which greater than 10% of the integrated absorption in the visible range from 350 nm to 750 nm is attributable to $N_s^0$ defects, may be used directly as the provided CVD diamond material in the method according to the invention, this provided diamond being irradiated to form the irradiated diamond material, and then subjected to an anneal at a temperature of at least 700°C and at most 900°C for at least 0.1 hour to form the treated diamond material containing NV centres ("the NV-forming anneal"). This route from CVD growth stage to formation of treated diamond is illustrated as "route A" in Figure 2 of the accompanying drawings. Our investigations have shown that there does not appear to be a maximum annealing time. For practical reasons, the maximum anneal time is optionally at most 100 hours or at most 50 hours, or at most 24 hours.

Instead of being used directly as the provided diamond material in the method according to the invention, the CVD diamond material grown by the added oxygen CVD growth process, when it results in a provided diamond in which greater than 10% of the integrated absorption in the visible range from 350 nm to 750 nm is attributable to $N_s^0$ defects, may be considered to be a added-oxygen-CVD-grown precursor diamond material that is annealed at a temperature of at least 1600°C, preferably about 1800°C, more preferably about 2000°C in order to form the provided CVD diamond material. This first annealing at a temperature of at least 1600 °C shall be referred to hereinafter as the "preliminary high temperature annealing process" where such nomenclature is desirable for clarity to distinguish it from the subsequent NV-forming anneal completed after the irradiation stage. A CVD diamond material made by the added oxygen CVD growth process and then subjected to the high temperature annealing process will form the provided CVD diamond as used in the method according to the invention, which provided CVD diamond having an absorption spectrum with a total integrated absorption in the visible range from 350 nm to 750 nm such that more than 10% of the integrated absorption is attributable to $N_s^0$. This route to the provided CVD diamond material is illustrated as "route B" in Figure 2. When this route is followed, both the added-oxygen-CVD-grown precursor-diamond-material and the provided diamond material have a total integrated absorption in the visible range from 350 nm to 750 nm such that more than 10% of the integrated absorption would be attributable to $N_s^0$ defects. It is thought that the preliminary high temperature annealing process may reduce still further any X defects in the grown CVD diamond material, which may be advantageous for certain embodiments.

Another possibility is for CVD diamond material to be grown using a more conventional CVD process, for example of the type disclosed in WO 03/052177. Such a process, as noted above may result in a diamond material with an absorption spectrum with a total integrated absorption in the visible range from 350 nm to 750 nm such that less than 10% of the integrated absorption would be attributable to $N_s^0$ defects. In other words the contribution of other defects to the visible part of the spectrum would be greater than 90%. We shall refer to this diamond material as the "traditional-CVD-grown precursor diamond material" in this specification, the word precursor being used to show it is a grown CVD diamond material that is different from and precedes the "provided CVD diamond material" defined by the method of the present invention. The word traditional being used to distinguish the route to the CVD grown precursor material from that described for route B above.

We have found that if selected traditional-CVD-grown precursor diamond material (or indeed CVD diamond material grown by the added oxygen process in such a way that it results in diamond in which less than 10% of the integrated absorption in the visible range from 350 nm to 750 nm is attributable to $N_s^0$ defects) is subjected to the above mentioned high temperature annealing process the result is a diamond material with an absorption spectrum with a total integrated absorption in the visible range from 350 nm to 750 nm such that more than 10% of the integrated absorption is attributable to $N_s^0$ defects, i.e. it results in the provided CVD diamond material according to the present invention. That provided diamond material can then be irradiated and subject to the final NV-forming annealing process as before. This route is shown in Figure 2 as "route C".

Without limiting the invention in any way, it is thought that the high temperature annealing process causes the aforementioned X defects to reconfigure in some way, so that they contribute less to the visible range of the absorption spectrum.

Routes A, B and C described above each produce the provided CVD diamond as used in the method according to the invention, and advantageously results in a CVD diamond comprising $N_s^0$, but having an absorption spectrum with a total integrated absorption in the visible range from 350 nm to 750 nm such that greater than 10% of the integrated absorption is attributable to $N_s^0$. In practice it is thought desirable, at least for some applications, for this ratio to be as high as possible. This means that the preliminary process, e.g. of routes A, B and C, result in a CVD diamond that does not contain, or contains at a minimal or reduced level, the X defects described hereinbefore as being responsible for the 350 nm, 510 nm, and ramp feature seen in the absorption spectrum of CVD diamond containing nitrogen, where X defects are thought to be responsible for the brown colouration.

Where route C is followed to form the provided CVD diamond, then the X defects are removed by the preliminary high temperature annealing process, or substantially minimised, or at least reduced. Where route A is followed i.e. the added oxygen CVD growth process under conditions where it results in diamond in which greater than 10% of the integrated absorption in the visible range from 350 nm to 750 nm is attributable to $N_s^0$ defects) is used, then the said X defects are not formed, or are formed to a minimal or reduced extent compared to processes without the additional oxygen. Where route B i.e. the added oxygen process (under conditions where it results in diamond in which greater than 10% of the integrated absorption in the visible range from 350 nm to 750 nm is attributable to $N_s^0$ defects) combined with a preliminary high temperature annealing process then the said X defects are still further reduced, if any were formed in the growth process.

The said provided CVD diamond, which is preferably provided by following one of the above described routes A, B or C, consequently has a colour which is not dominated by brown defects that do not contain nitrogen. It may be a yellow hue, that colour being dominated by the presence of single substitutional nitrogen $N_s^0$ or it may be a substantially colourless where lower concentrations of $N_s^0$ are present.

It is possible to differentiate, from measurements made on the final treated CVD diamond material, between diamonds made by a process involving a high temperature anneal (routes B and C in Figure 2) and those made by process that does not involve a high temperature anneal (e.g. route A in Figure 2).

CVD diamond material which has undergone the high temperature annealing process can be distinguished from that which has not, since CVD diamond material which has undergone the high temperature annealing process will contain one or more of the spectroscopic characteristics set out in Table 2A:

Table 2A

| Feature | Limit | Experimental Comment |
|---|---|---|
| 3107 cm$^{-1}$ | Present (>0.1 cm$^{-1}$) | Measured by room temperature FTIR with 1 cm$^{-1}$ wavenumber resolution |
| 3123 cm$^{-1}$ | Low or absent (<0.1 cm$^{-1}$) | Measured by room temperature FTIR with 1 cm$^{-1}$ wavenumber resolution |
| 1405 cm$^{-1}$ | Present (>0.05 cm$^{-1}$) | Measured by room temperature FTIR with 1 cm$^{-1}$ wavenumber resolution |
| 1453 nm | Present (>0.05 cm$^{-1}$) | Measured by room temperature FTIR with 1 cm$^{-1}$ wavenumber resolution |
| 1359 nm | Low or absent (<0.1 cm$^{-1}$) | Measured at room temperature using a Perkin Elmer lambda 19 spectrometer or equivalent with slit width of 1 nm and scan speed of 60 nm/min |
| Phosphorescence | Observable using DiamondView™ | |
| 503 nm (H3 defect) | Present (>10% of the normalized Raman) | Observable in PL (e.g. 488 nm excitation) measured at 77 K. |

The above spectroscopic properties will not be present in a treated CVD diamond material that has not undergone the high temperature anneal in the process to form the provided CVD diamond material.

In a first set of embodiments of methods according to the invention the treated diamond material (after irradiation and NV-forming annealing) will have one or more of the characteristics set out in Table 2A. Such a diamond material will generally be one which has been subjected to a high temperature annealing process as part of its history.

In a second set of embodiments of methods according to the invention the treated diamond material (after irradiation and NV-forming annealing) will have absorption characteristics falling outside one or more of those set out in Table 2A; for example the treated diamond material may have an absorption coefficient at 3107 cm$^{-1}$ that is absent or less than or equal to 0.1 cm$^{-1}$. Such a diamond material will generally be one which has not been subjected to a high temperature annealing process as part of its history.

While there may be some overlap between the first and second set of embodiments, generally materials that have been subjected to a high temperature annealing process will have all of the characteristics set out in Table 2A, whereas those that have not been subjected to the high temperature annealing process will have characteristics falling outside all of those set out in Table 2A.

For certain embodiments, it is desirable that the absolute value of $N_s^0{}_{(contrib)}$ is controlled for the provided diamond. It has been found that there is an advantageous minimum concentration of $N_s^0$ defects in the provided diamond such that sufficient NV colour centres are created on subsequent irradiation and annealing to generate the desired colour and/or spintronic properties. On the other hand, it has been found that if the concentration of $N_s^0$ defects is too high in the provided CVD diamond material, then following irradiation and NV-forming annealing the diamond material will have a darker colour, which may be undesirable in ornamental applications and/or lead to a reduced decoherence time T2 in spintronic applications.

For certain embodiments according to the invention, particularly for embodiments for making fancy pink coloured diamond material, the provided CVD diamond material may have a maximum concentration of $[N_s^0]$ defects of at most 5 ppm, (or at most 3 ppm, or at most 1 ppm, or at most 0.6 ppm, or at most 0.4 ppm, or at most 0.25 ppm, or at most 0.1 ppm, and/or may have a minimum concentration of $[N_s^0]$ of 0.1 ppm). For other embodiments, particularly for embodiments for spintronic applications, the provided CVD diamond material may have a minimum concentration of $[N_s^0]$ of 0.005 parts per billion (ppb). A lower $[N_s^0]$ concentration may be relevant for spintronic applications, since there is not a need to introduce sufficient NV centres to provide a fancy pale pink colouration (though as explained earlier diamond material with a pink colouration may be used in some cases for spintronic applications). For spintronic applications the maximum $[N_s^0]$ concentration in the provided CVD diamond material may be at most 5 ppm, (or at most 3 ppm, or at most 2 ppm, or at most 1 ppm, or at most 0.6 ppm, or at most 0.4 ppm, or at most 0.25 ppm, or at most 0.1 ppm, and or at most 0.05 ppm). This preferred maximum concentration for spintronic applications is set because at higher concentrations it is difficult or even impossible to resolve single defect centres.

Those skilled in the art will recognize that while controlling the $[N_s^0]$ concentration in the provided diamond it is also advantageous to control the total acceptor concentration [A], which for example might be associated with substitutional boron concentration $[B_s^0]$. In diamond containing both boron and nitrogen the following charge transfer is known to happen:

$$N_s^0 + B_s^0 \rightarrow N_s^+ + B_s^-.$$

The effect of this is to offer competing defect processes for the formation of NV⁻ defect centres.

Further, the presence of $B_s^0$ in sufficient concentrations can introduce blue colour to the provided diamond which can obscure any produced pink colour that is desired for the above mentioned ornamental applications.

Further, the presence of $B_s^0$ and the competing charge transfer processes it can drive in the material can lead to detrimental effects in applications such as spintronics. For example it can reduce both the T2 value and also the spectral stability of the photoluminescence associated with the NV⁻ defect.

For certain embodiments according to the invention, it is desirable for the provided diamond to have a total acceptor concentration (e.g. from substitutional boron measured for example using bound exciton or electrical measurements known to those skilled in the art) less than $5 \times 10^{16}$ cm⁻³, preferably less than $5 \times 10^{15}$ cm⁻³, more preferably less than $5 \times 10^{14}$ cm⁻³, even more preferably less than $5 \times 10^{13}$ cm⁻³ and most preferably less than $1 \times 10^{13}$ cm⁻³.

Alternatively it is desirable for the provide diamond to have a $[N_s^0]$ : [A] ratio (where [A] might be $B_s^0$) >2:1, preferably 10:1, more preferably >30:1, more preferably >60:1, more preferably >100:1, most preferably >1000:1.

It is known that if there is uncompensated boron in a diamond material this may be compensated for by irradiating to introduce isolated vacancies, the isolated vacancies combining with the boron. So in some embodiments according to the invention, if the diamond material does contain uncompensated boron (for example in a concentration >$5 \times 10^{15}$ cm⁻³) then the irradiation step may be carried out to introduce sufficient isolated vacancies to compensate the boron and to provide excess that will then form NV centres on annealing. The level of additional irradiation needed for boron compensation could be determined empirically by the person skilled in the art. Total boron in the material may be quantified using techniques known to the skilled person. Secondary ion mass spectroscopy (SIMS) may be used for example to ascertain the total boron concentration. The uncompensated boron may be ascertained using either the induced absorption measured in the infrared part of the diamond spectrum, or through Hall or electrical transport measurements, in a manner known to the skilled person.

Since diamond is a wide band gap semiconductor, diamond material, and in particular diamond material containing defects, does not necessarily have a well defined Fermi level. At room temperature (*i.e.* about 300 K), charge that is initially trapped at a defect having an energy level that is relatively shallow compared with either the valence band maximum or the conduction band minimum, will reach an equilibrium distribution via transport after thermal excitation to the valance or conduction bands. However, diamond material may contain defects having energy levels that are relatively deep within the band gap such that, at room temperature, there is a low probability for electrons to be thermally excited between the valence band and the defect or between the defect and the conduction band. When such defects are present, the charge distribution across the various defects may depend on the thermal and excitation history of the sample. In such cases, to the extent that the optical absorption properties of the material depend on the charge state of defects within it, they will also depend on the thermal and excitation history of the sample. For example, the proportions of isolated substitutional nitrogen defects that exist in the neutral charge state may depend on the prior thermal and excitation history of the sample and therefore the proportion of the total optical absorption that is attributable to this neutral defect will also depend on the history of the sample.

For the avoidance of doubt, when the history of the sample is not specified the properties of the material described in this invention should be taken to be properties that can be measured with no additional excitation of the sample during the measurement other than that required in making the measurement.

Preferably the properties are measured after the sample has been irradiated with light from a deuterium lamp under the following conditions:

(a) distance between the sample and the lamp of about 10 cm or less;
(b) lamp operating electrical power of at least 10 Watts; and
(c) a duration of between about 5 minutes and about 60 minutes.

In particular, the properties are measured after the sample has been irradiated with light from a deuterium lamp under the following conditions:

(a) distance between the sample and the lamp of 8 cm;

(b) lamp operating electrical power of 10 Watts; and

(c) a duration of 10 minutes.

Deuterium lamps (also known as "deuterium arc lamps") are widely used in spectroscopy where a continuous output is required between wavelengths of about 180 nm and about 370 nm.

The provided CVD diamond material used in the method according to the first aspect of the present invention preferably has at least about 50%, alternatively at least about 80%, alternatively at least about 90%, alternatively at least about 95% of the volume of the synthetic CVD diamond material formed from a single growth sector. This single growth sector is preferably a {100} or a {110} growth sector. The material of the single growth sector preferably has $N_s^0$ levels within $\pm 20\%$ of the mean for greater than about 50% of the volume of the growth sector, alternatively greater than about 60% of the volume of the growth sector, alternatively greater than about 80% of the volume of the growth sector. Using a provided synthetic CVD diamond material that has been grown from a single growth sector is advantageous. Surfaces with different crystallographic orientations exhibit strongly differential uptake of nitrogen impurity and a synthetic CVD diamond material comprising more growth sectors therefore tends to show more undesirable zones with different colour, resulting from the different concentrations of $N_s^0$ in different growth sectors.

Another advantage of having provided CVD diamond from predominantly a single growth sector is that in different growth sectors there may be different quantities, distributions and types of defects other than $N_s^0$.i.e. different $N_s^0$:X defect ratios. The optimum irradiation and anneal treatment will therefore be different for different sectors, which would not be practically possible.

The provided CVD diamond material used in the method according to the present invention, and also the treated CVD diamond material resulting from the method of the present invention may form part of a larger piece of diamond material. For example, a CVD diamond layer may be grown with no nitrogen in the source gas, so that that layer contains substantially no $N_s^0$ defects. Then the source gas could be adjusted to incorporate nitrogen and a subsequent layer may be grown containing nitrogen, and having immediately (if the growth process is appropriate), or after a preliminary high temperature annealing process, an absorption spectrum where the limits defined by the main method claim for contribution to the total integrated absorption spectrum by the $N_s^0$ defects are satisfied. Then if the whole diamond (or only the new growth if masking is used) is irradiated and then subject to the NV forming anneal then NV centres will form in the said subsequent layer only of the grown and treated CVD diamond material. As would be apparent to the person skilled in the art multiple layers could also be grown with the appropriate nitrogen and [$N_s^0$] defect concentrations, so that the provided CVD diamond material used in the method according to the invention forms part, e.g. one or multiple layers of a larger piece of diamond material. As another possibility control of the irradiation may be used such that the treated CVD diamond material used in the method of the present invention may form part of a larger piece of diamond material. It is well known that the depth of penetration of irradiation is dependent on the energy of the irradiation. So in preferred embodiments an irradiation energy is selected such that the irradiation penetrates only part of the depth of a CVD diamond material. This means that isolated vacancies would be introduced only in the penetrated part of the irradiated CVD diamond material, and hence that penetrated part of the CVD diamond material would be the "provided CVD diamond material" used in the method of the present invention, and after the subsequent NV forming annealing process NV centres would be introduced substantially only into the penetrated part of the diamond material.

Where the provided CVD diamond material provides only part of a larger piece of diamond material as discussed above, that provided CVD diamond material alone may have the advantageous optical or spintronic properties described for certain embodiments of the invention. Thus for example a top or embedded layer or layers of a large piece of CVD diamond material may have a pale pink colouration. Where any other non-pale-pink layers are substantially colourless the colour of the larger piece of diamond material is dominated by the pale pink layer(s). Similarly a top, or embedded layer or layers of a large piece of CVD diamond material may have improved spintronic properties.

In some embodiments according to the invention at least 50% or 60% or 70% or 80% or 90% or substantially the whole diamond stone may have substantially the same colour and/or substantially uniform [NV] concentration (by which we mean the same [NV] concentration $\pm$ 20%).

In other embodiments according to the invention of diamond stone may comprise layers or pockets of diamond material of the same colour and/or substantially uniform [NV] concentration.

Thus as can be seen, the source gas during the growth process can be controlled to produce a provided CVD diamond material forming part of a larger piece of diamond material; also the irradiation energy can be controlled to produce a provided CVD diamond material forming part of a larger piece of diamond material. The NV forming annealing process can only be applied to the bulk of any larger piece of diamond material; that is you cannot easily anneal only part of a whole stone.

Steps (ii) and (iii) of methods according to the invention comprise irradiating the provided diamond and annealing the irradiated diamond respectively. The step of irradiation acts to introduce isolated vacancies, V, into the diamond, and the subsequent annealing step acts to create NV centres as discussed hereinbefore.

The second step (ii) in the method according to the invention comprises irradiating the provided CVD diamond material. In a preferred method according to the invention the step of irradiating the provided CVD diamond material introduces into the material a isolated vacancy concentration $[V_T]$ in parts per million (ppm) which is greater than 0.1 x $[N_s^0]$ concentration in ppm in the provided CVD diamond material, and is less than 0.9 x $[N_s^0]$ concentration in ppm in the provided CVD diamond material i.e.:

$$0.1 \text{ x } [N_s^0] < [V_T] < 0.9 \text{ x } [N_s^0]$$

Generally, the isolated vacancy concentration $[V_T]$ is given by the sum of $[V^0]$ and $[V^-]$, where $[V^0]$ is the concentration of neutral isolated vacancies, and $[V^-]$ is the concentration of negatively charged isolated vacancies, both in ppm, and both $[V^0]$ and $[V^-]$ concentrations are determined from the GR1 and ND1 absorption features of the absorption spectrum of the irradiated diamond in a manner described hereinafter. It is possible that the irradiation might introduce vacancies in other forms, e.g. as pairs or in possible isolated positively charged vacancies $[V^+]$. However, the inventors did not observe any features in the irradiated diamond material that could be associated with such vacancy pairs or positive vacancies.

Electron, neutron or gamma radiation can be used. Electron irradiation is preferable over neutron irradiation as the higher energy neutrons can cause cascade damage which is undesirable as the formed vacancy chains can be more difficult to anneal out and lead to detrimental colour effects and reduced T2.

Electron irradiation is typically carried out with a beam source in the energy range 0.8 MeV to 12 MeV. The preferred energy is that which introduces a near uniform concentration of isolated vacancies in the N doped diamond, while minimizing the formation of cascade damage e.g. vacancy chains. For the optimum results reported here it was found that 4.5 MeV provided a good compromise between these two factors.

For larger samples, rotation of the sample during irradiation, or repeated rotation followed by irradiation, can assist in achieving the uniformity of the created isolated vacancies throughout the volume of the stone.

Factors such as diamond temperature, beam energy, beam flux, and even the starting diamond's properties can affect the $[V_T]$ produced for a fixed experimental irradiation set-up and time. Irradiation is typically carried out with the sample mounted under ambient conditions -300 K with only minimal temperature rise during the irradiation dose (e.g. less than 100 K). However, factors such as beam energy and beam flux can lead to sample heating. Preferably the sample is held as cold as possible (with even cryogenic cooling at 77 K being advantageous under some circumstances) to enable high dose rates without compromising temperature control and thus minimize the irradiation time. This is advantageous for commercial reasons. Calibration of the dose applied against the isolated vacancies produced for the particular provided diamond being used in order to satisfy these limits on $[V_T]$ concentration introduced will form part of the skilled person's responsibilities before carrying out the method of the present invention. Such calibration techniques are routine for the person skilled in the art.

Advantageously the proportion of NV defects compared to all other defects, now described as Z is as high as possible. Specifically, at least for some embodiments, it is desirable for NV$^-$:Z to be as high as possible for spintronic applications, whereas for the fancy pale pink colour it is desirable for the total NV ($[NV^-] + [NV^0]$) concentration to Z to be as high as possible. Once conversion of $N_s^0$ defects to NV centres has taken place, the remaining defects, Z, include: (i) the previously identified "X defects" previously noted as responsible for the 350 nm, the 510 nm peak, and the ramp factor in the absorption spectrum; (ii) excess isolated vacancies; (iii) excess vacancy chains $V_{chains}$; (iv) interstitial defects that have not annealed out, and (v) any un-converted $N_s^0$ defects. For gem or other coloured diamond material applications this is because Z defects introduce other colours into the diamond which would mask the pink colour or simply reduce the lightness. For spintronic applications it is because these Z defects can lead to a reduction in T2 or reduced spectral stability of the NV$^-$ zero phonon line.

For both coloured diamond material and/or spintronic applications, it is advantageous to have an [NV] concentration above a certain minimum level but below a certain maximum level. For the spintronic applications the $[NV^-]$ concentration is preferably in the range $10^7 < [NV^-] < 10^{13}$ cm$^{-3}$, more preferably $10^9 < [NV^-] < 10^{11}$ cm$^{-3}$. For the coloured diamond material applications, e.g. for a 0.5 ct round brilliant cut gem, the $[NV_T]$ (= $[NV^-] + [NV^0]$) concentration is preferably $10^{14} < [NV_T] < 10^{18}$ cm$^{-3}$ more preferably $5 \times 10^{15} < [NV_T] < 9 \times 10^{16}$ cm$^{-3}$.

Concentrations in ppm given in the present specification for the different defects, $[NV^{+/-}]$ and $[V^{0/-}]$, may be calculated in a known standard manner by integrating the area of peaks from the absorption spectrum of the diamond usually collected at liquid nitrogen temperatures and using published coefficients for comparison to calculate concentration. For concentrations of NV centres and isolated vacancies, the spectra are advantageously obtained at 77 K, using liquid nitrogen to cool the samples, since at that temperature sharp peaks at -741 nm and -394 nm attributable to V$^0$ and V$^-$ and at 575 nm and 637 nm are seen attributable to NV$^0$ and NV$^-$ defects respectively. The coefficients that are used for the calculations of concentrations of NV centres and isolated vacancies in the present specification are those set out by G. Davies in Physica B, 273-274 (1999), 15-23, as detailed in Table 3 below.

Table 3

| Defect [label] | Calibration (meV cm$^{-1}$) |
| --- | --- |
| V$^-$ [ND1] | $A_{ND1} = (4.8 \pm 0.2) \times 10^{-16}[V^-]$ |
| V$^0$ [GR1] | $A_{GR1} = (1.2 \pm 0.3) \times 10^{-16}[V^0]$ |
| NV$^-$ | $A_{NV^-} = (1.4 \pm 0.35) \times 10^{-16}[NV^-]$ |
| NV$^0$ | $A_{NV^0} = (1.4 \pm 0.35) \times 10^{-16}[NV^0]$ |

In Table 3, "A" is the integrated absorption (meV cm$^{-1}$) in the zero phonon line of the transition, measured at 77 K, with the absorption coefficient in cm$^{-1}$ and the photon energy in meV. The concentration is in cm$^{-3}$.

Control of the irradiation and anneal treatment is therefore advantageous in order to achieve the desired high NV:Z ratio in the treated diamond. Table 4 sets out the matrix to be considered when selecting appropriate irradiation periods and annealing times.

Table 4

| Irradiation dose | Anneal time | Result |
| --- | --- | --- |
| Lower than optimum | Any | Insufficient NV formed - material remains colourless and NV:Z ratio is too low for spintronic applications. |
| Optimum | Optimum or longer than optimum | Maximum number of NV centres formed. NV:Z defect ratio is maximised. All excess isolated vacancies are removed (as indicated by absence of GR1 and ND1 centres on spectrum). Minimal concentration of other vacancy/interstitial complexes formed. Diamond material has bright pale pink colour |
| Longer than optimum or optimum | Shorter than optimum | Too many isolated vacancies remaining in the material (as indicated by GR1 and ND1 centres of the absorption spectrum of the treated diamond material). Result is a diamond material having a flat spectrum and a grey component or appearance. |
| Longer than optimum | Optimum or longer than optimum | Insufficient nitrogen to continue to form NV centres. So excess vacancies remain (not combined with N$_s^0$ defects) either as isolated vacancies or vacancy complexes. NV:Z ratio is lower than optimum . |

The optimum irradiation dose for a given material can be empirically determined by irradiating the CVD diamond for longer than ideal, annealing in steps and measuring the concentration of NV defects formed and V defects remaining. The concentration of NV centres formed will saturate out, the concentration of isolated vacancies consumed to reach this point is the optimum concentration of isolated vacancies (the target vacancy concentration) to introduce into the material. The target vacancy concentration is preferably controlled to within $\pm$ 10% preferably to within $\pm$ 8% most preferably to within $\pm$ 5%. A description of determination of target vacancy concentration is given later in this specification with reference to the examples.

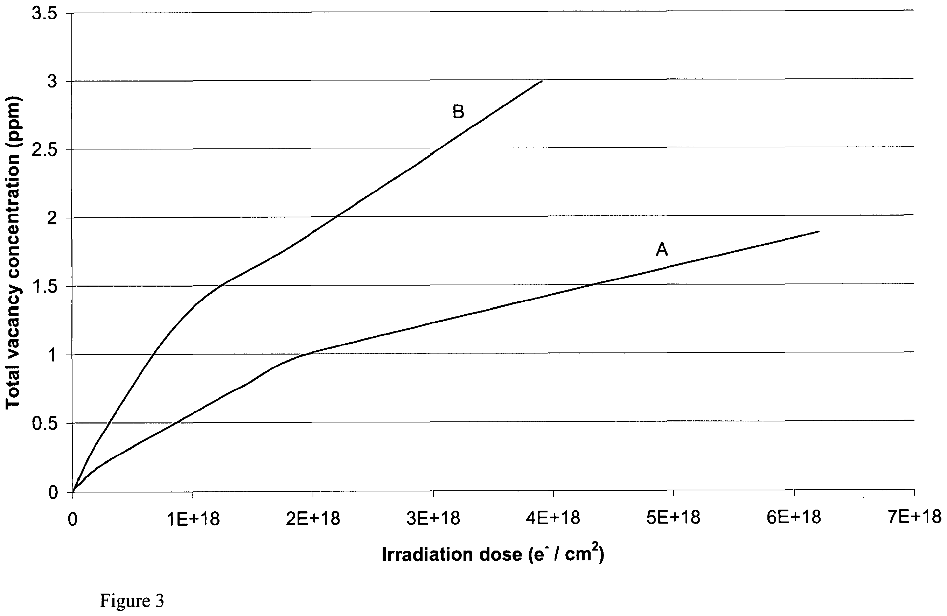

In general the greater the irradiation dose, the greater the number of isolated vacancies created. The exact position of the curve for different provided diamond materials will vary and is empirically determined for any particular sample. Curves for two different starting diamond materials (labelled A and B) are shown in figure 3.

The number of isolated vacancies created can depend not only on the period of the irradiation dose, but also on the number and nature of defects in the provided CVD diamond. Therefore to calculate the desired dose of electron irradiation the vacancy production rate is also calculated for the given irradiation conditions as would be known to those skilled in the art. This procedure forms part of the calibration of dose applied against isolated vacancies produced referred to earlier.

Therefore the position of the curve can be found and the irradiation dose required to produce the optimum vacancy concentration can be extrapolated. For 4.5 MeV electrons the inventors found electron irradiation doses in the range $3 \times 10^{16}$ - $3 \times 10^{17}$ e$^-$ / cm$^2$ most desirable, corresponding to vacancy (V$^0$ + V$^-$) concentrations post irradiation of 0.04 - 0.3 ppm, and in the range 10%$\rightarrow$90 % of the N$_s^0$ in the starting material

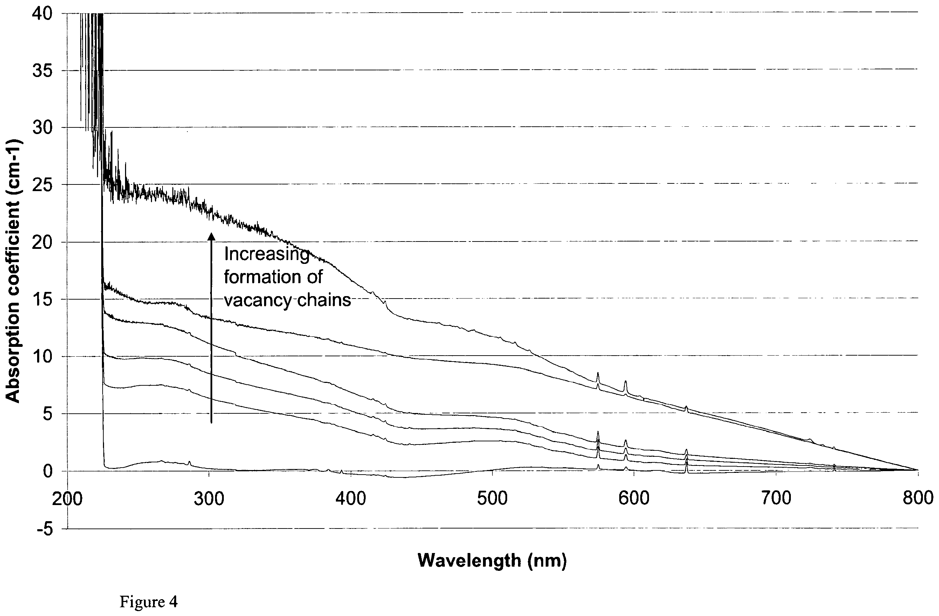

As noted above, particularly with respect to table 4 the NV forming annealing process following irradiation converts at least some of the isolated vacancies introduced by the irradiation process to NV centres. Non-converted isolated vacancies may remain as single isolated vacancies or may, as a result of the NV forming annealing process, agglomerate together to form so-called "vacancy chains". For diamonds with a higher than optimum V concentration, after the desired anneal to maximize the formation of NV it was found that the absorption spectrum contained very few isolated vacancies characterized by low levels of $V^0$ and $V^-$ defects, but a characteristic rise in absorption from 450 nm. Without being bound by theory this is thought to be associated with the formation of vacancy chains. The strength of this feature was characterized by the measured increase in the absorption coefficient after the irradiation and annealing stages in the 200-450 nm region, with a maximum value at 250 nm of <20 cm$^{-1}$, preferably <15 cm$^{-1}$, more preferably <10 cm$^{-1}$, most preferably <5 cm$^{-1}$. Figure 4 shows how the absorption coefficient at 250 nm increases as the formation of vacancy chains increases. Their presence affects both the optical and spintronic properties of any diamond material containing them, generally in a disadvantageous manner.

Preferably the irradiated diamond material is subjected to a NV forming anneal at a temperature of at least 700°C, more preferably at least 750°C in a stabilizing atmosphere (e.g. vacuum <10$^{-5}$ mTorr). The maximum annealing temperature is preferably less than 900°C, more preferably less than 850°C, preferably done at 800°C The annealing period may be at least 0.1 hours, or may be at least 2, 3 or 6 hours. We have found that prolonging the anneal is not disadvantageous in terms of affecting the properties of the diamond material, but beyond a certain period of anneal, does not change the properties of the diamond any further. Therefore for convenience and cost reasons annealing for periods beyond the time when properties stabilise is not preferred. The optimum annealing time is therefore considered to be until the properties of the diamond material substantially stabilise. Typically this optimum annealing period is in the range 6 to 10 hours, more advantageously for about 8 hours.

The concentration of [NV] and [V] defects are determined using low temperature optical absorption measurements using methodology described herein.

Based on the optimization of the irradiation dose and anneal conditions the treated diamond material, after the irradiation and NV-forming anneal steps, has one or more, and preferably all of the following characteristics as set out in Table 5:

Table 5

| | |
|---|---|
| $[V^0]$ (GR1) | <0.3 ppm<br>preferably <0.2 ppm<br>more preferably <0.1<br>even more preferably <0.05 ppm<br>most preferably <0.01 ppm |
| $[V^-]$ (ND1) | <0.3 ppm<br>preferably <0.2 ppm<br>more preferably <0.1 |
| | even more preferably <0.05 ppm<br>most preferably <0.01 ppm |
| $[N_s^0]$ | preferably <5 ppm<br>preferably <3 ppm<br>preferably <1 ppm<br>preferably <0.6 ppm<br>preferably <0.4 ppm<br>more preferably <0.25<br>even more preferably <0.1 ppm<br>most preferably <0.05 ppm |
| V chain absorption at 250 nm | <20 cm$^{-1}$<br>preferably <15 cm$^{-1}$<br>more preferably <10 cm$^{-1}$<br>most preferably <5 cm$^{-1}$ |
| $[NV^- + NV^0] : [N^0_S]$ | >0.16<br>preferably >0.2<br>more preferably >0.3<br>even more preferably >0.4<br>most preferably >0.5 |

The treated diamond material, after the irradiation and NV-forming anneal steps preferably has a T2 measured at room temperature that is greater than 100 $\mu$s, or greater than 200 $\mu$s, or greater than 300 $\mu$s, or greater than 400 $\mu$s, or greater than 500 $\mu$s, or greater than 600 $\mu$s, or greater than 800 $\mu$s.

The spin coherence time (T2) of a single electron spin in a NV⁻ centre can be probed using Hahn echo decay. Adapted to optically detected magnetic resonance, the Hahn echo pulse sequence consists of the well-known $\pi/2$ - T □□- $\pi$ -□ T □- $\pi/2$ series of microwave pulses. The last pulse is devoted to convert the spin echo phenomenon into populations, measurable by fluorescence detection. Prior to performing the Hahn echo decay measurement a single NV centre is selected using a confocal microscope system with 532 nm excitation. This allows bulk samples to be scanned and individual NV centres selected. After selecting a NV centre a Hanbury Brown-Twiss experiment is performed to determine that the centre truly is singular. The results of the Hanbury Brown-Twiss experiment show a characteristic anti-bunching signature in the coincidence rate when there is only one NV centre.

Upon selection of a NV centre the centre is excited optically then a series of microwave pulses are used to observe the electron spin precession.

The main decoherence mechanism is spectral diffusion, that happens when the electron spins that generate the echo pulse are subject to fluctuating dipolar or hyperfine fields generated by nuclear spins. A stochastic theory of this effect can be derived by considering the electron spin Larmor frequency as a random variable. The amplitude of the echo pulse can be calculated using an ensemble average, equivalent to time averaging in a single-spin experiment. The

$$A(2\tau) = \exp\left[-\frac{1}{6}\frac{\Delta^2}{T_m}(2\tau)^3\right]$$

result is where $\tau$ is the time interval between the $\pi/2$ and $\pi$ pulses, $\Delta$ is the parameter characterizing the local field relaxation, and where $T_m$ is the phase memory time.

In an otherwise perfect diamond lattice which only contains a low concentration of NV⁻ ($<10^{11}$ cm⁻³) centres, it is found that coupling to the $^{13}$C nuclear spin S=1/2 remains a factor which limits the coherence time. The electron spin feels a change in the local field if a pair of nuclei changes its mutual spin configuration. Flip-flop processes are then strongly suppressed when in close proximity to the NV⁻ centre, because the nuclei experience a strong hyperfine coupling

$$\delta = \left[2S\frac{\gamma_e}{\gamma_n}\right]^{1/4}a,$$

induced energy shift with respect to the spin bath. The decoupling radius $\delta$ is given by where S is the electron spin quantum number, $\gamma_e$ and $\gamma_n$ are the gyromagnetic ratios of electron and nuclear spins, and $a$ is the average nearest neighbour separation between nuclear spins.

Methodology and the benefits of reducing the $^{13}$C nuclear spin concentration are described in WO2010/010352 and WO2010/010344. The material of this invention could be incorporated into diamond with a higher $^{12}$C:$^{13}$C ratio than typical natural abundance.

In a preferred method according to the present invention the CVD processes carried out so that the diamond material that results is carbon 12 [$^{12}$C] enriched. As well known in the art, carbon exists in two isotopic forms: carbon 12 [$^{12}$C], and carbon 13 [$^{13}$C]. In naturally occurring diamond the percentage [$^{13}$C] concentration is typically 1.1%. For some applications, for example the spintronic applications of interest in the present specification, [$^{13}$C] nuclei act as additional spin defects. Therefore for preferred processes according to the present invention the provided diamond material comprises less than 0.9 percent, preferably less than 0.6 percent, preferably less than 0.4 percent, preferably less than 0.2 percent, preferably less than 0.1 percent, preferably less than 0.01 percent, [$^{13}$C]. This [$^{13}$C] remains through irradiation and the NV-forming annealing process. Therefore in one embodiment of method according to the invention the treated (irradiated and NV-forming annealed) diamond material also comprises less than 0.9 percent [$^{13}$C].

The present invention also provides a diamond material made by a method according to the first aspect of the invention.

A second aspect of the present invention provides a CVD diamond material which when in the form of a 0.5 carat RBC (Round Brilliant Cut) is graded fancy pale pink and has the following absorption characteristic measured at room temperature:

| Feature | Limit | Experimental Comment |
|---|---|---|
| 3107 cm⁻¹ | Absent or ≤ 0.1 cm⁻¹ | Measured by room temperature FTIR with 1 cm⁻¹ wavenumber resolution |

The terminology fancy pale pink diamond material is defined as diamonds which have a clear and distinct pink colour (Diamond grading ABC The Manual, by Verena Pagel-Theisen, Rubin & Son, Belgium, 9th Edition, 2001, Page 67).

The pink CVD synthetic single crystal diamond having the following colour characteristics, as set out in Table 6, measured for an equivalent 0.5 ct Round Brilliant Cut (RBC) diamond.

Table 6

| Characteristic | Range |
|---|---|
| Hue angle $\alpha$ | 0° - 60°<br>preferably 10 - 55<br>more preferably 15 - 52 |
| C* | 3 - 20<br>preferably 3 - 15<br>more preferably 3 - 10 |
| L* | >70<br>more preferably >75<br>most preferably >80 |

and also has the following absorption characteristic measured at room temperature:

| Feature | Limit | Experimental Comment |
|---|---|---|
| 3107 cm$^{-1}$ | Absent or $\leq$ 0.1 cm$^{-1}$ | Measured by room temperature FTIR with 1 cm$^{-1}$ wavenumber resolution |

Preferred diamond materials according to the second aspect of the present invention have characteristics falling outside all those set out in Table 2A.

The colour of the irradiated and annealed diamond can be quantified in a well established manner using "CIE L*a*b* Chromaticity Coordinates". The use of CIE L*a*b* Chromaticity Coordinates in diamond is described in WO 2004/022821, the entire disclosure of which is incorporated herein by reference. a* and b* are plotted as x and y axes of a graph and the hue angle is measured from the positive a* axis towards the positive b* axis. Thus a hue angle of greater than 90° and less than 180° lies in the upper left quadrant of the a*b* graph. In this scheme for describing colour L* is the lightness and a fourth coordinate C* is the saturation.

The perceived colour of an object depends on the transmittance/absorbance spectrum of the object, the spectral power distribution of the illumination source and the response curves of the observer's eyes. The CIE L*a*b* chromaticity coordinates (and therefore hue angles) quoted herein have been derived in the way described below. Using a standard D65 illumination spectrum and standard (red, green and blue) response curves of the eye (G. Wyszecki and W. S. Stiles, John Wiley, New York-London-Sydney, 1967) CIE L*a*b* chromaticity coordinates of a parallel-sided plate of diamond have been derived from its transmittance spectrum using the relationships below, between 350 nm and 800 nm with a data interval of 1 nm:

$S_\lambda$ = transmittance at wavelength $\lambda$

$L_\lambda$ = spectral power distribution of the illumination

$x_\lambda$ = red response function of the eye

$y_\lambda$ = green response function of the eye

$z_\lambda$ = blue response function of the eye

$$X = \Sigma_\lambda \, [S_\lambda \, x_\lambda \, L_\lambda] \, / \, Y_0$$

$$Y = \Sigma_\lambda \, [S_\lambda \, y_\lambda \, L_\lambda] \, / \, Y_0$$

$$Z = \Sigma_\lambda \, [S_\lambda \, z_\lambda \, L_\lambda] \, / \, Y_0$$

Where $Y_0 = \Sigma_\lambda\, y_\lambda\, L_\lambda$

$$L^* = 116\,(Y/Y_0)^{1/3} - 16 = \text{Lightness} \qquad (\text{for } Y/Y_0 > 0.008856)$$

$$a^* = 500[(X/X_0)^{1/3} - (Y/Y_0)^{1/3}] \qquad (\text{for } X/X_0 > 0.008856,\ Y/Y_0 > 0.008856)$$

$$b^* = 200[(Y/Y_0)^{1/3} - (Z/Z_0)^{1/3}] \qquad (\text{for } Z/Z_0 > 0.008856)$$

$$C^* = (a^{*2} + b^{*2})^{1/2} = \text{saturation}$$

$$h_{ab} = \arctan\,(b^* / a^*) = \text{hue angle}$$

Modified versions of these equations must be used outside the limits of $Y/Y_0$, $X/X_0$ and $Z/Z_0$. The modified versions are given in a technical report prepared by the Commission Internationale de L'Eclairage (Colorimetry (1986)).

It is standard to plot a* and b* coordinates on a graph with a* corresponding to the x axis and b* corresponding to the y axis. Positive a* and b* values correspond respectively to red and yellow components to the hue. Negative a* and b* values correspond respectively to green and blue components. The positive quadrant of the graph then covers hues ranging from yellow through orange to red, with saturations (C*) given by the distance from the origin.

It is possible to predict how the a*b* coordinates of diamond with a given absorption coefficient spectrum will change as the optical path length is varied. In order to do this, the reflection loss must first be subtracted from the measured absorbance spectrum. The absorbance is then scaled to allow for a different path length and then the reflection loss is added back on. The absorbance spectrum can then be converted to a transmittance spectrum which is used to derive the CIE L*a*b* coordinates for the new thickness. In this way the dependence of the hue, saturation and lightness on optical path length can be modelled to give an understanding of how the colour of diamond with given absorption properties per unit thickness will depend on the optical path length.

L*, the lightness, forms the third dimension of the CIE L*a*b* colour space. It is useful to understand the way in which the lightness and saturation vary as the optical path length is changed for diamond with particular optical absorption properties. The method described in the preceding paragraph can also be used to predict how the L*C* coordinates of diamond with a given absorption coefficient spectrum depend on the optical path length.

The C* (saturation) numbers can be divided into saturation ranges of 10 C* units and assigned descriptive terms as below.

| | |
|---|---|
| 0-10 | weak |
| 10-20 | weak-moderate |
| 20-30 | moderate |
| 30-40 | moderate-strong |
| 40-50 | strong |
| 50-60 | strong-very strong |
| 60-70 | very strong |
| 70-80+ | very very strong |

Similarly the L* numbers can be divided up into lightness ranges as follows:

| | |
|---|---|
| 5-15 | very very dark |
| 15-25 | very dark |
| 25-35 | dark |
| 35-45 | medium/dark |
| 45-55 | medium |
| 55-65 | light/medium |
| 65-75 | light |
| 75-85 | very light |

(continued)

| 85-95 | very very light |
|---|---|

There are four basic colour tones defined by the following combinations of lightness and saturation:

Bright: Light and high saturation, Pale: Light and low saturation,
Deep: High saturation and dark, Dull: Low saturation and dark.

The preferred hue angle, and a*, b*, C* and L* values provide a quantitative measure the quality and colour of synthetic CVD diamond material of the present invention. These colour properties are advantageous because they give the diamond a pink colour and can be used for ornamental purposed such as gemstones for jewellery, or for coloured filters or the like.

Another embodiment of the present invention provides a CVD synthetic single crystal diamond material having the following characteristics:

| $[V^0]$ GR1 | <0.3 ppm |
|---|---|
| $[V^-]$ ND1 | <0.3 ppm |
| $[N_s^0]$ | <0.5 ppm |
| [NV] | $\geq 10^{12}$ cm$^{-3}$, optionally $\geq 10^{13}$, optionally $\geq 10^{14}$, optionally $\geq 10^{15}$ |

The diamond material optionally has the following additional characteristic:

| [V chains] absorption | <20 cm$^{-1}$ at 250 nm |
|---|---|

Such a diamond material may find application for fancy pale pink coloured applications, or for spintronic applications. For spintronic applications $[NV^-]$ is optionally $\geq 10^{12}$ cm$^{-3}$, optionally $\geq 10^{13}$ cm$^{-3}$, optionally $\geq 10^{14}$ cm$^{-3}$, optionally $\geq 10^{15}$ cm$^{-3}$.

The diamond material optionally also, or alternatively, has the following additional characteristic:

| T2 | > 100 $\mu$s |
|---|---|

Such a diamond material finds particular application for spintronics.

Preferably T2 is >200 $\mu$s, preferably >300 $\mu$s, preferably >400 $\mu$s, preferably >500 $\mu$s, preferably >600 $\mu$s, preferably >800 $\mu$s.

CVD synthetic single crystal diamond material having the above characteristics is particularly preferred for spintronic applications.

In some embodiments according to the present invention the ratio $([NV^-]+[NV^0])/[N_s^0]$ in the synthetic CVD diamond material is greater than 0.16.

In some embodiments according to the present invention the CVD synthetic single crystal diamond material contains at least $10^7$ cm$^{-1}$ NV$^-$ centres, and/or at most $10^{13}$ cm$^{-3}$ NV$^-$ centres. These preferred values for the number of NV$^-$ centres are particularly applicable for spintronic applications.

For other embodiments, particularly, though not exclusively for fancy pale pink diamond material, the CVD synthetic single crystal diamond material may contain at least $9 \times 10^{15}$ cm$^{-3}$ NV$_T$ (=NV$^-$ + NV$^0$) centres, especially a minimum of $10^{14}$ cm$^{-3}$ NV$_T$ centres and/or a maximum of $10^{18}$ cm$^{-3}$ NV$_T$ centres.

For other embodiments according to the invention the CVD synthetic single crystal diamond material contains at least $10^7$ cm$^{-3}$ NV$^-$ centres, and/or at most $10^{13}$ cm$^{-3}$ NV$^-$centres. These preferred numbers of NV$^-$ centres are particularly preferred for CVD diamond material according to the invention for spintronic applications.

In some embodiments according to the invention the CVD synthetic crystal diamond material according to the invention contains less than 0.9 percent $^{13}$C.

A preferred application of CVD synthetic single crystal diamond material according to the invention is a gemstone for ornamental use, or any other industrial use making use of the pink colouration of the diamond material, for example filters or the like.

Another preferred application of CVD synthetic single crystal diamond material according to the invention is a spintronic device.

As noted above, the diamond material may be a gemstone for ornamental purposes and preferably has pale tonal characteristics. As an alternative the diamond material may be a spintronic device. Other applications for the diamond material would be apparent to the person skilled in the art.

The present invention also provides use of a CVD synthetic single crystal diamond material according to the invention as a gemstone, and use of a CVD synthetic single crystal diamond material according to the invention as a spintronic device

Embodiments of the invention will now be described, by way of example, with reference to the accompanying drawings, wherein:

Figure 1, which has been referred to above, shows a spectral decomposition of the UV/visible absorption spectrum for an orange/brown CVD synthetic diamond layer;

Figure 2, which has been referred to above, is a flow chart that shows routes to the provided diamond material used in the method of the present invention and the subsequent treatment (irradiation and NV-forming anneal) steps;

Figure 3 is a graph that shows the increase in vacancy concentration introduced into CVD diamond material by increasing the irradiation dose;

Figure 4 is a series of absorption spectra which show the increase in absorption with increasing formation of vacancy chains;

Figure 5 shows the absorption spectrum for the provided CVD diamonds of one comparative sample of diamond material, and one provided CVD diamond material according to the invention;

Figures 6a-6d show colour model plots for the samples of Figure 5 after irradiation and NV-forming annealing treatments; and

Figure 7 shows the absorption spectrum for the provided CVD diamond material sample according to the invention of Figure 5 after the irradiation and NV-forming annealing treatment.

Examples

HPHT diamond substrates suitable for synthesising single crystal CVD diamond of the invention were laser sawn, lapped into substrates, polished to minimise subsurface defects such that the density of defects is below $5 \times 10^3$ /mm$^2$, and generally is below $10^2$ /mm$^2$. Polished HPHT plates 3.6 mm x 3.6 mm square by 500 $\mu$m thick, with all faces {100} having a surface roughness $R_Q$ at this stage of less than 1 nm, were mounted on a refractory metal disk, and introduced into a CVD diamond growing reactor.

1) The CVD diamond reactor was pre-fitted with point of use purifiers, reducing unintentional contaminant species in the incoming gas stream to below 80 ppb.

2) An *in situ* oxygen plasma etch was performed using 50/40/3000 sccm (standard cubic centimetre per second) of $O_2$/Ar/$H_2$ and a substrate temperature of 760°C.

3) This moved without interruption into a hydrogen etch with the removal of the $O_2$ from the gas flow.

4) This moved into the growth process by the addition of the carbon source (in this case $CH_4$) and dopant gases. For these examples the $CH_4$ flowing at 165 sccm, nitrogen was present in the process gas at different levels for the different samples (as set out in Table 7), provided from a calibrated source of for example 100 ppb $N_2$ either as air in Ar or $N_2$ in $H_2$,, and for some examples $O_2$ was also present in the process gas.

Table 7

| Example | Nitrogen dopant present in the process gas (ppm) | Oxygen flow present in the process gas (ppm) |
|---|---|---|
| 1 | 0.7 | 0 |
| 2 and 7 | 1.8 | 0 |

(continued)

| Example | Nitrogen dopant present in the process gas (ppm) | Oxygen flow present in the process gas (ppm) |
|---------|--------------------------------------------------|----------------------------------------------|
| 3 - 6   | 1.0                                              | 13740                                        |

5) On completion of the growth period, the substrate was removed from the reactor and the CVD diamond layer removed from the substrate by laser sawing and mechanical polishing techniques.

6) This produced a CVD sample which had typical dimensions ~3.1x5x5 mm.

This grown CVD diamond is the "provided diamond" defined by the claims of the present specification.

The electron irradiation was carried out with a 4.5 MeV electron beam source to a dose of $2.6 \times 10^{17}$ e$^-$/cm$^2$ (equivalent to 15 minutes on 50% scan-width and 20 mA beam current). Diamond samples to be irradiated are mounted in indium on a water cooled copper block to prevent the samples being heated above 350 K.

All NV forming anneals described in the examples were done in an Elite tube furnace (model TSH 16/50/180-2416CG and 2716O/T). The annealing was done under in a vacuum of $<1\times10^{-5}$ mbar, by ramping the temperature between room temperature and the dwell temperature at 3°C min$^{-1}$.

Table 8 shows the $N_s^0$ concentrations in ppm, and the percentage of the total integrated absorption attributable to $N_s^0$ defects for the diamond material samples provided as above. The table records the consequent colour of the diamond material, concentrations of NV$^0$, NV$^-$, V$^0$ and V$^-$, $N_s^0$ and absorption at 250 nm (indicative of the concentration of vacancy chains) after the irradiation and annealing treatment.

Table 8 means comparative test sample

| Sample Number | Route to "provided CVD diamond material (see Fig 2) n/a for comparative examples | $N_s^0$ conc. In provided CVD diamond (ppm) | Percentage of integrated absorption in visible spectrum of provided CVD diamond, attributable to $N_s^0$ defects | RT UV/Vis absorption characteristics in provided CVD diamond (cm$^{-1}$) | Irradiation dose (e/cm$^2$) | Vacancy concentration post irradiation (ppm) | NV forming anneal time and temperature (hours) (°C) | Observed colour of diamond after irradiation and annealing | Colour characteristics L* C* $\alpha$ | NV concentration (ppm) Post irradiation and anneal | V0 and V-concentration (ppm) | $N_s^0$ remaining in material post treatment (ppm) |
|---|---|---|---|---|---|---|---|---|---|---|---|---|
| 1* | N/A | 0.1 | 5.8 | 270 nm = 1.16<br>350 nm = 0.78<br>510 nm = 0.30 | 2.6 x 10$^{17}$ | $V^0$ = 0.17<br>$V^-$ = 0.033 | 8 hrs at 800°C | Dull pinkish-brown | L* = 80.2<br>C* = 5.05<br>$\alpha$ = 67.7 | $NV^0$ = 0.031<br>$NV^-$ = 0.0086 | $V^0$ = 0.046<br>$V^-$ = 0.0099 | 0.03 |
| 2* | N/A | 0.4 | 8.4 | 270 nm = 2.23<br>350 nm = 1.09<br>510 nm = 0.45 | 2.6 x 10$^{17}$ | $V^0$ = 0.25<br>$V^-$ = 0.12 | 8 hrs at 800°C | Dull pinkish-brown | L* = 61.7<br>C* = 12.72<br>$\alpha$ = 57.8 | $NV^0$ = 0.078<br>$NV^-$ = 0.038 | $V^0$ = 0.041<br>$V^-$ = 0.0098 | 0.3 |
| 3* | N/A | 0.35 | 28.4 | 270 nm = 1.42<br>350 nm = 0.63<br>510 nm = 0.23 | 2 x 10$^{16}$ | $V^0$ = 0.0097<br>$V^-$ = 0.009 | 8 hrs at 800°C | Colourless | L* = 78.1<br>C* = 4.79<br>$\alpha$ = 68.7 | $NV^0$ = 0.012<br>$NV^-$ = 0.015 | $V^0$ = 0.0097<br>$V^-$ = 0.009 | 0.3 |
| 4* | N/A | 0.35 | 28.4 | 270 nm = 1.42<br>350 nm = 0.63<br>510 nm = 0.23 | 2 x 10$^{18}$ | $V^0$ = 1.1<br>$V^-$ = 0.3 | 1 hr at 800°C | Grey | L* = 69.3<br>C* = 10.8<br>$\alpha$ = 83.8 | $NV^0$ = 0.055<br>$NV^-$ = 0.019 | $V^0$ = 0.45<br>$V^-$ = 0.053 | 0.3 |
| 5 | Route A | 0.35 | 28.4 | 270 nm = 1.42<br>350 nm = 0.63<br>510 nm = 0.23 | 2.6 x 10$^{17}$ | $V^0$ = 0.06<br>$V^-$ = 0.12 | 8 hrs at 800°C | Pale pink | L* = 87.4<br>C* = 4.26<br>$\alpha$ = 44.93 | $NV^0$ = 0.061<br>$NV^-$ = 0.0057 | $V^0$ = 0.068<br>$V^-$ = 0.027 | 0.25 |
| 6* | N/A | 0.35 | 28.4 | 270 nm = 1.42<br>350 nm = 0.63<br>510 nm = 0.23 | 2 x 10$^{18}$ | $V^0$ = 1.1<br>$V^-$ = 0.3 | 8 hrs at 800°C | Orange pink | L* = 70.5<br>C* = 17.08<br>$\alpha$ = 71.7 | $NV^0$ = 0.092<br>$NV^-$ = 0.019 | $V^0$ = 0.21<br>$V^-$ = 0.034 | 0.25 |
| 7 | Route C | 0.33 | 30 | 270 nm = 1.05<br>350 nm = 0.26<br>510 nm = 0.12 | 2.6 x 10$^{17}$ | $V^0$ = 0.05<br>$V^-$ = 0.11 | 8 hrs at 800°C | Pale pink | RBC graded as fancy pale pink | $NV^0$ = 0.023<br>$NV^-$ = 0.008 | $V^0$ = 0.033<br>$V^-$ = 0.007 | 0.27 |

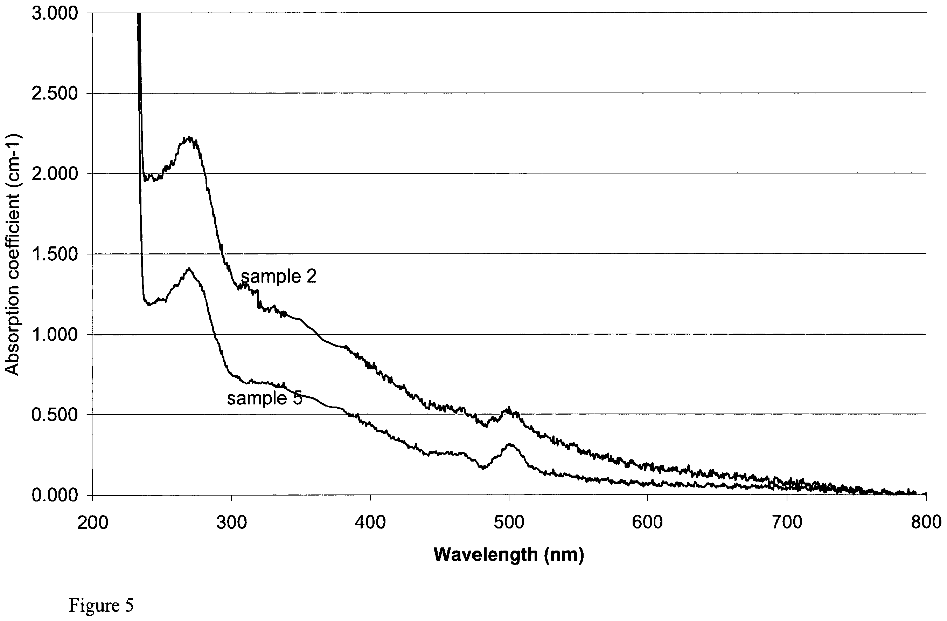

Figure 5 shows the absorption spectrum for the provided CVD diamonds of sample 2 (a comparative example) and of sample 5. Table 9 sets out the absorption coefficients at 270 nm (attributable to $N_s^0$) and at 350 nm and 510 nm (attributable to part of the X defects and thought to be responsible for the brown colouration, as described earlier). The calculated concentration in ppm of $N_s^0$ defects and the percentage contribution to the total integrated absorption in the visible range, calculated as described earlier, is also included for completeness, duplicating some of the information from Table 8.

Table 9

| Sample Number | 270 nm absorption coefficient (cm$^{-1}$) | 350 nm absorption coefficient (cm$^{-1}$) | 510 nm absorption coefficient (cm$^{-1}$) | $[N_s^0]$ (ppm) | $[N_s^0]$: X (%) |
|---|---|---|---|---|---|
| 2 | 2.25 | 1.09 | 0.45 | 0.4 | 8.4 |
| 5 | 1.42 | 0.63 | 0.23 | 0.35 | 28.4 |

From figure 5 and the data in tables 8 and 9, it can be seen that for sample 2 (comparative) where 0.4 ppm $N_s^0$ is present, and which has been made using a conventional CVD process, integrating the spectrum in the manner described earlier, the $N_s^0$ contribution to the visible part of the spectrum of sample 2 is found to be 8.4%, and hence outside the scope of the present invention which requires the provided CVD diamond to have a $N_s^0$ contribution to the total absorption in the visible range to be at least 10%.

In contrast, sample 5 has a similarly suitable high concentration of $N_s^0$ but reduced absorption associated with X defects. These figures give an $N_s^0$ contribution to the visible part of the spectrum for the provided diamond of sample 5 of 28.4%, i.e. within the scope of the claims of the present invention, being greater than 10%.

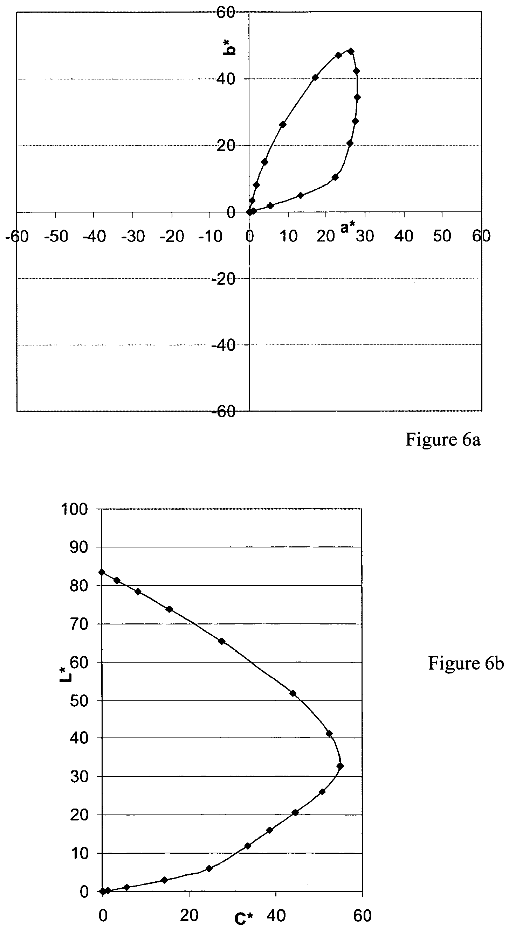

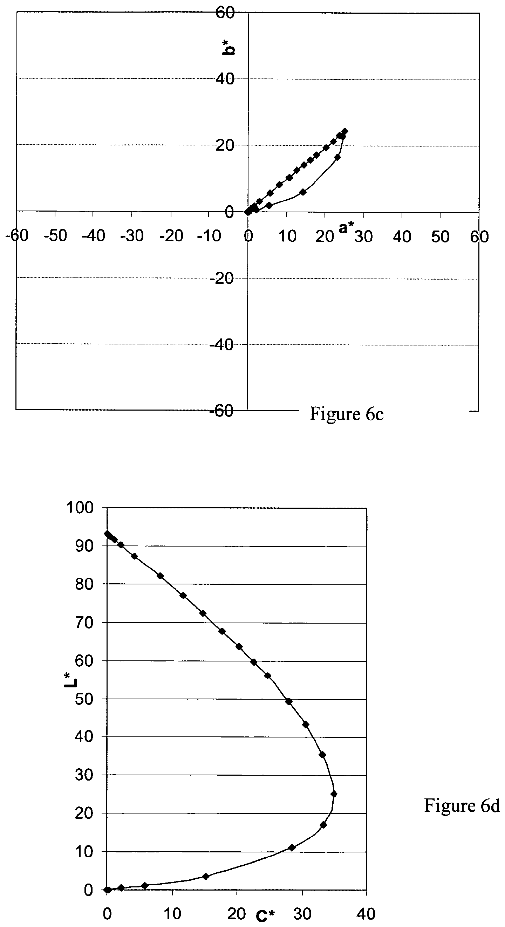

Figures 6a-6d show colour model plots for comparative sample 2 and sample 5 after their irradiation and annealing treatments; Figure 6a is an a*b* plot for sample 2, Figure 6b is a L*C* plot for sample 2, Figure 6c is an a*b* plot for sample 5, and Figure 6b is a L*C* plot for sample 5.

Table 10 sets out the values of the colour model parameters for these samples.

Table 10

| Colour model parameter | Sample 2 - dull pinkish-brown (comparative) | Sample 5 - pale pink |
|---|---|---|
| L* | 61.7 | 87.4 |
| a* | 6.76 | 3.02 |
| b* | 10.78 | 3.01 |
| C* | 12.72 | 4.26 |
| Hue angle | 57.8° | 44.93° |

From Figures 6a-6d and Table 10 we can see that sample 5 has a higher L* value (increased lightness), i.e. within the scope of the claims of the present invention, being >70, whereas samples 2 does not.

As can be seen, samples 5 and 7 achieve a pale pink colour, which in the gem trade is considered more desirable than the dull pink colour for samples 1 and 2. From these results it is deduced that, at least for ornamental applications, the percentage integrated absorption in the visible spectrum of the provided CVD diamond attributable to $N_s^0$ defects should be at least 10%, preferably at least 12%, and for some embodiments at least 15%.

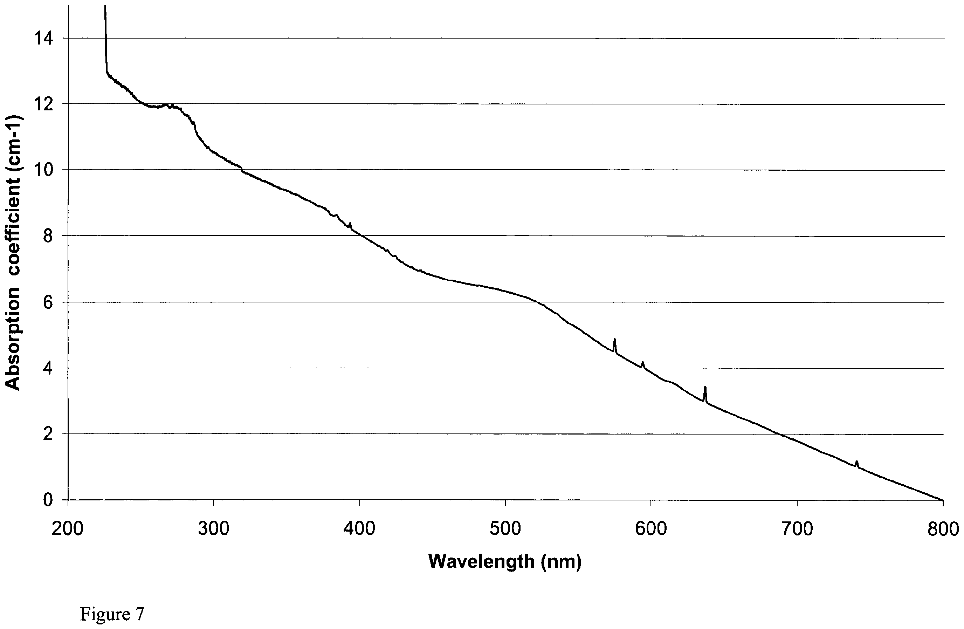

Figure 7 shows the absorption spectrum for sample 5 after irradiation and annealing treatment and Table 11 shows the calculated concentrations of various defects in the sample in ppm.

Table 11

| Defect | Concentration in ppm |
|---|---|
| $[NV^0]$ | 0.061 ppm |
| $[NV^-]$ | 0.0057 ppm |
| [NV] total | 0.0667 ppm |
| $[V^0]$ (GR1) | 0.068 ppm |
| $[V^-]$ (ND1) | 0.027 ppm |

(continued)

| Defect | Concentration in ppm |
|---|---|
| [V] total | 0.095 ppm |
| Absorption at 250 nm (indicative of vacancy chains) | 12 cm$^{-1}$ |

From figure 7 and table 11 it can be seen that GR1 and ND1 peaks (indicative of excess isolated vacancies $V^0$ and $V^-$ respectively are less than 0.3 cm$^{-1}$ and 0.3.cm$^{-1}$ respectively, indicating a total concentration of isolated vacancies ($V^0 + V^-$ combined) of 0.095 ppm and the absorption at 250 nm is <20 cm$^{-1}$.

From this spectrum the NV concentration formed was also found to be >0.03 ppm.

Table 8 includes a number of comparative examples which fall outside the scope of the present invention for the following reasons. Considering for example the method claims, samples 1 and 2 have integrated absorption in the visible spectrum of the provided CVD diamond attributable to $N_s^0$ of <10%. Irradiation and NV-forming annealing steps result in treated diamond material with hue angles that fall outside the preferred range 0°-60° for sample 1, and L* values that fall outside the preferred range for sample 2. Sample 3 is under-irradiated, it falls outside the main method claim as <0.05 ppm of isolated vacancies were introduced, and the treated material has an [NV° + NV⁻] : [$N_s^0$] concentration less than the preferred concentration of <0.16 ppm and a hue angle which falls outside the preferred range 0°-60°. The over-irradiated diamond, sample 4, which was annealed for a short duration to minimise the formation of vacancy chains falls outside the main method claim as the irradiation dose introduced > 1 ppm of isolated vacancies, the treated diamond post anneal has a L* value less than the preferred values, a C* value greater than the preferred values, and a hue angle outside the preferred range of 0°-60°. Sample 6 which was over irradiated and annealed for a long duration also falls outside the main method claim as the irradiation dose introduced > 1 ppm of isolated vacancies. It has a hue angle outside of the range of 0°-60° and the absorption at 250 nm associated with vacancy chains is >20 cm$^{-1}$. A similar analysis can be applied for the comparative examples with respect to the article claims.

Calculating the optimum concentration of isolated vacancies to introduce into a sample within the range described in the claims is advantageous where it is desired to produce the optimum pale pink coloured diamond material and/or the ideal material for spintronic applications. A method that can be used to calculate this is to take the approximately 6 samples of the provided diamond and irradiate them all for significantly longer than ideal, so as to introduce > 1 ppm of isolated vacancies into the material. Each piece of the irradiated diamond material can then be annealed at 800°C for an increasing duration. The concentrations of V°, V⁻, NV$^0$ and NV⁻ can then be measured using the method described earlier. An optimum concentration of isolated vacancies ($V^0 + V^-$) to introduce (the target vacancy concentration) is the concentration consumed to reach the point where the concentration of NV centres (NV° + NV⁻) is substantially constant (by which we mean it shows less than a 10% change). Table 12 sets out the measured results achieved for one example for different anneal times.

Table 12

| Anneal at 800°C | [$V^0$] | [$V^-$] | Total [V] | [NV$^0$] | [NV⁻] | Total [NV] |
|---|---|---|---|---|---|---|
| No anneal | 0.5 | 0.05 | 0.55 | 0 | 0 | 0 |
| Ramp to 800°C only - no dwell | 0.32 | 0.035 | 0.35 | 0.011 | 0 | 0.011 |
| 1 hr dwell | 0.22 | 0.032 | 0.25 | 0.017 | 0.0028 | 0.019 |
| 2 hrs dwell | 0.13 | 0.011 | 0.14 | 0.034 | 0.0044 | 0.038 |
| 4 hrs dwell | 0.09 | 0.0098 | 0.099 | 0.027 | 0.0033 | 0.030 |
| 8 hrs dwell | 0.02 | 0 | 0.02 | 0.03 | 0.0023 | 0.032 |

For this example the [NV] is effectively constant after 2 hrs dwell at 800°C, at which point 0.41 ppm of isolated vacancies have been consumed therefore this would have been the ideal concentration to introduce. If we introduce less than this the maximum concentration of NV centres will not be achieved, if we introduce more than this the remaining isolated vacancies will either remain as isolated vacancies if a short anneal is applied or be converted to vacancy chains if a longer anneal is applied, both of which are detrimental to the final diamond material properties. The irradiation dose required to introduce the calculated concentration of isolated vacancies will be specific to the diamond material used. For this example the curve of vacancy concentration with irradiation dose is shown as figure 3 (diamond material A). For this example introducing 0.4 ppm of isolated vacancies would require an irradiation dose of 6 x 10$^{17}$ e⁻/cm$^2$.

Claims

1. A method of fabricating a single crystal CVD diamond material, the method comprising:

  i) providing a single crystal diamond material that has been grown by CVD and contains single substitutional nitrogen ($N_s^0$) and has an absorption spectrum with a total integrated absorption in the visible range from 350 nm to 750 nm such that at least 10% of the integrated absorption is attributable to $N_s^0$;

  (ii) irradiating the provided CVD diamond material so as to introduce isolated vacancies V into at least part of the provided CVD diamond material such that the concentration of isolated vacancies in the irradiated diamond material is at least 0.05 ppm and at most 1 ppm; and

  (iii) annealing the irradiated diamond material so as to form NV centres in at least part of the provided CVD diamond material from at least some of the single substitutional nitrogen ($N_s^0$) defects and the introduced isolated vacancies,

  wherein the single crystal CVD diamond material thus produced has the following absorption characteristic measured at room temperature:

| Feature | Limit | Experimental Comment |
|---|---|---|
| 3107 cm$^{-1}$ | Absent or $\leq$ 0.1 cm$^{-1}$ | Measured by room temperature FTIR with 1 cm$^{-1}$ wavenumber resolution |

and which has a colour which is graded fancy pale pink when in the form of a 0.5 ct RBC and characterized as follows for an equivalent 0.5 ct RBC:

| Characteristic | Range |
|---|---|
| Hue angle $\alpha$ | 0°-60° |
| C* | 3.0-20 |
| L* | >70 |

2. A method according to claim 1, wherein the step of irradiating the provided CVD diamond material introduces into the material a total isolated vacancy concentration $[V_T]$ in parts per million which is greater than 0.1 x $[N_s^0]$ concentration in ppm in the provided CVD diamond material, and is less than 0.9 x $[N_s^0]$ concentration in ppm in the provided CVD diamond material.

3. A method according to claim 1 or 2, comprising providing a substrate and a source gas; and allowing homoepitaxial diamond synthesis on the substrate to wherein the synthesis environment comprises nitrogen at an atomic concentration of from about 0.4 ppm to about 50 ppm; and wherein the source gas comprises: (a) an atomic fraction of hydrogen $H_f$, from about 0.4 to about 0.75; (b) an atomic fraction of carbon, $C_f$, from about 0.15 to about 0.3; (c) an atomic fraction of oxygen, $O_f$, from about 0.13 to about 0.4; wherein $H_f + C_f + O_f = 1$; wherein the ratio of atomic fraction of carbon to the atomic fraction of oxygen Cf:Of, satisfies the ratio of about 0.45:1 < Cf:Of < about 1.25:1; wherein the source gas comprises hydrogen atoms added as hydrogen molecules, $H_2$, at an atomic fraction of the total number of hydrogen, oxygen and carbon atoms present of between 0.05 and 0.4; and wherein the atomic fractions $H_f$, $C_f$ and $O_f$ are fractions of the total number of hydrogen, oxygen and carbon atoms present in the source gas, the diamond synthesis process producing the said CVD diamond material provided in step (i) of the method of claim 1 or 2, or providing an added-oxygen-CVD-grown-precursor-diamond-material that can be treated to produce the said CVD diamond material provided by step (i) of the method of claim 1 or 2.

4. A method according to claim 3, wherein the diamond synthesis process produces a precursor-diamond-material, and the method comprises treating the precursor diamond material by annealing the grown CVD diamond material at a temperature of at least 1600°C to produce the said CVD diamond provided by step (i) of the method.

5. A method according to claim 1 or 2, comprising providing a traditional-CVD-grown-precursor-diamond-material comprising single substitutional nitrogen ($N_s^0$) and having an absorption spectrum with a total integrated absorption in the visible range from 350 nm to 750 nm such that less than 10% of the integrated absorption is attributable to $N_s^0$, and then annealing the grown CVD diamond material at a temperature of at least 1600°C to produce the said CVD diamond material provided by step (i) of the method.

6. A method according to previous claims whereby the anneal time is chosen to reach a stage whereby any subsequent anneal at the same temperature leads to less than 10 % change in the concentration of NV centres.

7. A method according to any preceding claim, wherein the provided diamond material prior to the irradiation has the following absorption characteristics measured at room temperature:

| Designation | Starts (nm) | Ends (nm) | Peak (nm) | Absorption coefficient at peak (cm$^{-1}$) |
|---|---|---|---|---|
| 270 nm $N_s^0$ | 220 | 325 | 270 | < 4 |
| 350 nm band Part of "X" | 270 | 450 | 350 $\pm$10 | < 0.7 |
| 510 nm band Part of "X" | 420 | 640 | 510 $\pm$50 | < 0.3 |

8. A method according to any preceding claim, wherein at least 50% of the provided CVD diamond material has been formed from a single growth sector.

9. A method according to any preceding claim, wherein the provided CVD diamond material in step (i) has a boron concentration [B] that is less than $5 \times 10^{15}$ cm$^{-3}$

10. A method according to any preceding claim wherein the provided CVD diamond material in step (i) of the method is part of a larger piece of diamond material.

11. A method according to any preceding claim, wherein the step of irradiating the provided CVD diamond material is carried out using an electron beam.

12. A CVD synthetic single crystal diamond material which has the following absorption characteristic measured at room temperature:

| Feature | Limit | Experimental Comment |
|---|---|---|
| 3107 cm$^{-1}$ | Absent or $\leq$ 0.1 cm$^{-1}$ | Measured by room temperature FTIR with 1 cm$^{-1}$ wavenumber resolution |

and which has a colour which is graded fancy pale pink when in the form of a 0.5 ct RBC and characterized as follows for an equivalent 0.5 ct RBC:

| Characteristic | Range |
|---|---|
| Hue angle $\alpha$ | 0°-60° |
| C* | 3.0-20 |
| L* | >70 |

13. A CVD synthetic single crystal diamond material according to claim 12, having the following characteristics:

| [V$^0$] GR1 | <0.3 ppm |
|---|---|
| [V$^-$] ND1 | <0.3 ppm |
| [$N_s^0$] | <0.5 ppm |
| [V chains] peak concentration | <20 cm$^{-1}$ at 250 nm |

14. A CVD synthetic single crystal diamond material according to claim 12, having the following characteristics:

| | |
|---|---|
| $[V^0]$ GR1 | <0.3 ppm |
| $[V^-]$ ND1 | <0.3 ppm |
| $[N_s^0]$ | <0.5 ppm |
| [NV] | $\geq 10^{12}$ cm$^{-3}$ |

**15.** A CVD synthetic single crystal diamond according to claim 14, having a $V_{chain}$ absorption at 250 nm that is less than 20 cm$^{-1}$.

**16.** A CVD synthetic single crystal diamond according to claim 14 or claim 15, having a T2 value that is greater than 100 $\mu$s.

**17.** A CVD synthetic single crystal diamond according to any of claims 12 to 16, wherein the ratio $([NV^-]+[NV^0])/[N_s^0]$ is greater than 0.16.

**18.** A CVD synthetic single crystal diamond material according to any of claims 12, 13 or 17, containing at least $10^7$ cm$^{-3}$ NV$^-$ centres.

**19.** A CVD synthetic single crystal diamond material according to any of claims 12 to 16 containing at most $10^{13}$ cm$^{-3}$ NV$^-$ centres.

**20.** A CVD synthetic single crystal diamond material according to any of claims 12 to 17 containing at least 9x $10^{15}$ cm$^{-3}$ NV$_T$ centres.

**21.** A CVD synthetic single crystal diamond material according to any of claims 12 to 18, or claim 21, containing at most $10^{18}$ cm$^{-3}$ NV$_T$ centres.


**Patentansprüche**

**1.** Verfahren zum Fertigen eines CVD-Einkristalldiamantmaterials, bei dem

(i) ein Einkristalldiamantmaterial bereitgestellt wird, das durch CVD gezüchtet worden ist und einzeln substitutionalen Stickstoff ($N_s^0$) enthält und ein Absorptionsspektrum mit einer gesamten integrierten Absorption im sichtbaren Bereich von 350 nm bis 750 nm aufweist, so dass mindestens 10 % der integrierten Absorption auf $N_s^0$ zurückführbar sind;
(ii) das bereitgestellte CVD-Diamantmaterial bestrahlt wird, um so isolierte Leerstellen V in mindestens einen Teil des bereitgestellten CVD-Diamantmaterials einzuführen, so dass die Konzentration der isolierten Leerstellen in dem bestrahlten Diamantmaterial mindestens 0,05 ppm und höchstens 1 ppm beträgt; und
(iii) das bestrahlte Diamantmaterial getempert wird, um NV-Zentren in mindestens einem Teil des bereitgestellten CVD-Diamantmaterials aus mindestens einigen der einzeln substitutionalen Stickstoff- ($N_s^0$)-Defekte und den eingeführten isolierten Leerstellen zu bilden,
wobei das so hergestellte CVD-Einkristallmaterial die folgenden Absorptionscharakteristika aufweist, gemessen bei Raumtemperatur:

| Merkmal | Grenzwert | Anmerkung zum Experiment |
|---|---|---|
| 3107 cm$^{-1}$ | Fehlend oder $\leq$ 0,1 cm$^{-1}$ | Gemessen bei Raumtemperatur FTIR mit einer Wellenzahlauflösung von 1 cm$^{-1}$ |

und es eine Farbe aufweist, die als extravagantes blassrosa klassifiziert wird, wenn es in Form eines 0,5 ct Rundbrilliantschliffs (RBC) vorliegt, und wie folgt für einen äquivalenten 0,5 ct RBC charakterisiert wird:

| Charakteristikum | Bereich |
|---|---|
| Farbwinkel $\alpha$ | 0° - 60° |
| C* | 3,0-20 |
| L* | >70 |

2. Verfahren nach Anspruch 1, bei dem der Schritt des Bestrahlens des bereitgestellten CVD-Diamantmaterials in das Material eine Gesamtkonzentration an isolierten Leerstellen $[V_T]$ in ppm einführt, die größer als 0,1 x Konzentration von $[N_s^0]$ in ppm in dem bereitgestellten CVD-Diamantmaterial ist und kleiner als 0,9 x Konzentration von $[N_s^0]$ in ppm in dem bereitgestellten Diamantmaterial ist.

3. Verfahren nach Anspruch 1 oder 2, bei dem ein Substrat und ein Quellgas bereitgestellt werden; und homoepitaxiale Diamantsynthese auf dem Substrat zugelassen wird, wozu die Syntheseumgebung Stickstoff in einer atomaren Konzentration von etwa 0,4 ppm bis etwa 50 ppm umfasst; und wobei das Quellgas umfasst: (a) einen atomaren Anteil an Wasserstoff, $H_f$, von etwa 0,4 bis etwa 0,75; (b) einen atomaren Anteil an Kohlenstoff, $C_f$, von etwa 0,15 bis etwa 0,3; (c) einen atomaren Anteil an Sauerstoff, $O_f$, von etwa 0,13 bis etwa 0,4; wobei $H_f + C_f + O_f = 1$; wobei das Verhältnis des atomaren Anteils an Kohlenstoff zu dem atomaren Anteil an Sauerstoff, $C_f:O_f$, das Verhältnis von etwa 0,45:1 $< C_f:O_f <$ etwa 1,25:1 erfüllt; wobei das Quellgas Wasserstoffatome umfasst, die als Wasserstoff-moleküle, $H_2$, zugefügt werden, bei einem atomaren Anteil der Gesamtanzahl von vorhandenen Wasserstoff-, Sauerstoff- und Kohlenstoffatomen zwischen 0,05 und 0,4; und wobei die atomaren Anteile $H_f$, $C_f$ und $O_f$ Anteile der Gesamtanzahl an Wasserstoff-, Sauerstoff- und Kohlenstoffatomen sind, die in dem Quellgas vorhanden sind, wobei das Diamantsyntheseverfahren das CVD-Material herstellt, welches in Schritt (i) des Verfahrens nach Anspruch 1 oder 2 bereitgestellt wird, oder ein gezüchtetes CVD-Vorläuferdiamantmaterial mit zugefügtem Sauerstoff bereitstellt, welches behandelt werden kann, um das CVD-Diamantmaterial herzustellen, welches durch Schritt (i) des Verfahrens nach Anspruch 1 oder 2 bereitgestellt wird.

4. Verfahren nach Anspruch 3, bei dem der Diamantsyntheseprozess ein Vorläuferdiamantmaterial produziert, und bei dem das Verfahren das Behandeln des Vorläuferdiamantmaterials umfasst, indem das gezüchtete CVD-Diamantmaterial bei einer Temperatur von mindestens 1600°C getempert wird, um das CVD-Diamantmaterial herzustellen, welches durch Schritt (i) des Verfahrens bereitgestellt wird.

5. Verfahren nach Anspruch 1 oder 2, bei dem ein traditionell gezüchtetes CVD-Vorläuferdiamantmaterial bereitgestellt wird, das einzeln substitutionalen Stickstoff $(N_s^0)$ umfasst und ein Absorptionsspektrum mit einer gesamten integrierten Absorption im sichtbaren Bereich von 350 nm bis 750 nm aufweist, so dass weniger als 10 % der integrierten Absorption auf $N_s^0$ zurückführbar sind, und dann das gezüchtete CVD-Diamantmaterial bei einer Temperatur von mindestens 1600°C getempert wird, um das CVD-Material herzustellen, das durch Schritt (i) des Verfahrens bereitgestellt wird.

6. Verfahren nach einem der vorhergehenden Ansprüche, bei dem die Temperzeit so gewählt wird, dass eine Stufe erreicht wird, wodurch jedwedes nachfolgende Tempern bei derselben Temperatur zu weniger als 10 % Änderung in der Konzentration der NV-Zentren führt.

7. Verfahren nach einem der vorhergehenden Ansprüche, bei dem das bereitgestellte Diamantmaterial vor der Bestrahlung die folgenden Absorptionscharakteristika aufweist, gemessen bei Raumtemperatur:

| Bezeichnung | Starts(nm) | Enden(nm) | Peak(nm) | Absorptionskoeffizient am Peak ($cm^{-1}$) |
|---|---|---|---|---|
| 270 nm $Ns^0$ | 220 | 325 | 270 | <4 |
| 350 nm Band Teil von "X" | 270 | 450 | 350 ± 10 | <0,7 |
| 510 nm Band Teil von "X" | 420 | 640 | 510 ± 50 | <0,3 |

8. Verfahren nach einem der vorhergehenden Ansprüche, bei dem mindestens 50 % des bereitgestellten CVD-Diamanten aus einem einzelnen Wachstumssektor gebildet sind.

**9.** Verfahren nach einem der vorhergehenden Ansprüche, bei dem das bereitgestellte CVD-Diamantmaterial in Schritt (i) eine Borkonzentration [B] aufweist, die kleiner als $5 \times 10^{15}$ cm$^{-3}$ ist .

**10.** Verfahren nach einem der vorhergehenden Ansprüche, bei dem das bereitgestellte CVD-Diamantmaterial in Schritt (i) des Verfahrens Teil eines größeren Stücks des Diamantmaterials ist.

**11.** Verfahren nach einem der vorhergehenden Ansprüche, bei dem der Schritt des Bestrahlens des bereitgestellten CVD-Diamantmaterials unter Verwendung eines Elektronenstrahls durchgeführt wird.

**12.** Synthetisches CVD-Einkristalldiamantmaterial, das die folgenden Absorptionscharakteristika aufweist, gemessen bei Raumtemperatur:

| Merkmal | Grenzwert | (Anmerkung zum Experiment |
|---|---|---|
| 3107cm$^{-1}$ | Fehlend oder $\leq$ 0,1 cm$^{-1}$ | Gemessen bei Raumtemperatur FTIR mit einer Wellenzahlauflösung von 1 cm$^{-1}$ |

und das eine Farbe aufweist, die als extravagantes blassrosa klassifiziert wird, wenn es in Form eines 0,5 ct Rundbrilliantschliffs (RBC) vorliegt, und wie folgt für einen äquivalenten 0,5 ct RBC charakterisiert wird:

| Charakteristikum | Bereich |
|---|---|
| Farbwinkel $\alpha$ | 0° - 60° |
| C* | 3,0-20 |
| L* | >70 |

**13.** Synthetisches CVD-Einkristalldiamantmaterial nach Anspruch 12 mit den folgenden Charakteristika:

| | |
|---|---|
| $[V^0]$ GR1 | <0,3 ppm |
| $[V^-]$ ND1 | <0,3 ppm |
| $[N_s^0]$ | <0,5 ppm |
| [V-Ketten] Peak-Konzentration | <20 cm$^{-1}$ bei 250 nm |

**14.** Synthetisches CVD-Einkristalldiamantmaterial nach Anspruch 12 mit den folgenden Charakteristika:

| | |
|---|---|
| $[V^0]$ GR1 | <0,3 ppm |
| $[V^-]$ ND 1 | <0,3 ppm |
| $[N_s^0]$ | <0,5 ppm |
| [NV] | $\geq 10^{12}$ cm$^{-3}$ |

**15.** Synthetisches CVD-Einkristalldiamant nach Anspruch 14 mit einer $V_{Kette}$-Absorption bei 250 nm, die unter 20 cm$^{-1}$ liegt.

**16.** Synthetischer CVD-Einkristalldiamant nach Anspruch 14 oder Anspruch 15 mit einem T2-Wert, der größer als 100 $\mu$s ist.

**17.** Synthetisches CVD-Einkristalldiamant nach einem der Ansprüche 12 bis 16, bei dem das Verhältnis $([NV] + [NV^0])$ / $[N_s^0]$ größer als 0,16 ist.

**18.** Synthetisches CVD-Einkristalldiamantmaterial nach einem der Ansprüche 12, 13 oder 17, das mindestens $10^7$ cm$^{-3}$ NV$^-$-Zentren enthält.

**19.** Synthetisches CVD-Einkristalldiamantmaterial nach einem der Ansprüche 12 bis 16, das höchstens $10^{13}$ cm$^{-3}$ NV$^-$-Zentren enthält.

**20.** Synthetisches CVD-Einkristalldiamantmaterial gemäß einem der Ansprüche 12 bis 17, das mindestens $9 \times 10^{15}$ cm$^{-3}$ NV$_T$-Zentren enthält.

**21.** Synthetisches CVD-Einkristalldiamantmaterial nach einem der Ansprüche 12 bis 18 oder Anspruch 21, das höchstens $10^{18}$ cm$^{-3}$ NV$_T$-Zentren enthält.

**Revendications**

**1.** Procédé de fabrication d'un diamant monocristallin obtenu par dépôt chimique en phase vapeur, le procédé comprenant :

    i) la fourniture d'un diamant monocristallin qui a été développé par dépôt chimique en phase vapeur et qui contient un mono-azote de substitution ($N_S^0$) et présente un spectre d'absorption ayant une absorption intégrée totale dans le domaine du visible de 350 nm à 750 nm de manière à ce qu'au moins 10 % de l'absorption intégrée soit attribuable à $N_S^0$ ;
    ii) l'irradiation du diamant fourni obtenu par dépôt chimique en phase vapeur de façon à introduire des lacunes isolées V dans au moins une partie du diamant fourni obtenu par dépôt chimique en phase vapeur de manière à ce que la concentration des lacunes isolées dans le diamant irradié soit d'au moins 0,05 ppm et d'au plus 1 ppm ; et
    iii) le recuit du diamant irradié de façon à former des centres NV (azote-lacune) dans au moins une partie du diamant fourni obtenu par dépôt chimique en phase vapeur à partir d'au moins certains des défauts des mono-azotes de substitution ($N_S^0$) et des lacunes isolées introduites, dans lequel le diamant monocristallin obtenu par dépôt chimique en phase vapeur ainsi produit a la caractéristique d'absorption suivante mesurée à température ambiante :

| Caractéristique | Limite | Commentaire expérimental |
|---|---|---|
| 3 107 cm$^{-1}$ | Absente ou $\leq 0,1$ cm$^{-1}$ | Mesurée par FTIR à température ambiante à une résolution du nombre d'onde de 1 cm$^{-1}$ |

et qui a une couleur qui est classée rose pâle spécial lorsqu'il est sous la forme d'un RBC (taillé rond-brillant) de 0,5 ct et caractérisé comme suit pour un RBC de 0,5 ct équivalent :

| Caractéristique | Plage |
|---|---|
| Angle de teinte $\alpha$ | 0°-60° |
| C* | 3,0-20 |
| L* | > 70 |

**2.** Procédé selon la revendication 1, dans lequel l'étape d'irradiation du diamant fourni obtenu par dépôt chimique en phase vapeur introduit dans le matériau une concentration totale de lacunes isolées [$V_T$] en parties par million qui est supérieure à $0,1 \times$ concentration [$N_S^0$] en ppm dans le diamant fourni obtenu par dépôt chimique en phase vapeur, et qui est inférieure à $0,9 \times$ concentration [$N_S^0$] en ppm dans le diamant fourni obtenu par dépôt chimique en phase vapeur.

**3.** Procédé selon la revendication 1 ou 2, comprenant la fourniture d'un substrat et d'un gaz source ; et le fait de permettre une synthèse de diamant homoépitaxié sur le substrat dans lequel l'environnement de synthèse comprend de l'azote à une concentration atomique d'environ 0,4 ppm à environ 50 ppm ; et dans lequel le gaz source comprend :

(a) une fraction atomique d'hydrogène $H_f$, d'environ 0,4 à environ 0,75 ; (b) une fraction atomique de carbone, $C_f$, d'environ 0,15 à environ 0,3 ; (c) une fraction atomique d'oxygène, $O_f$, d'environ 0,13 à environ 0,4 ; dans lequel $H_f + C_f + O_f = 1$ ; dans lequel le rapport de la fraction atomique de carbone à la fraction atomique d'oxygène $C_f/O_f$, satisfait le rapport d'environ $0,45/1 < C_f/O_f <$ environ $1,25/1$ ; dans lequel le gaz source comprend des atomes d'hydrogène ajoutés en tant que molécules d'hydrogène, $H_2$, à une fraction atomique du nombre total d'atomes d'hydrogène, d'oxygène et de carbone présents entre 0,05 et 0,4 ; et dans lequel les fractions atomiques $H_f$, $C_f$ et $O_f$ sont des fractions du nombre total d'atomes d'hydrogène, d'oxygène et de carbone présents dans le gaz source, le procédé de synthèse de diamant produisant ledit diamant obtenu par dépôt chimique en phase vapeur fourni à l'étape (i) du procédé selon la revendication 1 ou 2, ou la fourniture d'un diamant précurseur développé par dépôt chimique en phase vapeur à ajout d'oxygène qui peut être traité pour produire ledit diamant obtenu par dépôt chimique en phase vapeur fourni par l'étape (i) du procédé selon la revendication 1 ou 2.

4. Procédé selon la revendication 3, dans lequel le procédé de synthèse de diamant produit un diamant précurseur, et le procédé comprend le traitement du diamant précurseur par le recuit du diamant développé par dépôt chimique en phase vapeur à une température d'au moins 1 600 °C pour produire ledit diamant obtenu par dépôt chimique en phase vapeur fourni par l'étape (i) du procédé.

5. Procédé selon la revendication 1 ou 2, comprenant la fourniture d'un diamant précurseur développé par dépôt chimique en phase vapeur traditionnel comprenant un mono-azote de substitution ($N_S^0$) et présentant un spectre d'absorption ayant une absorption intégrée totale dans le domaine du visible de 350 nm à 750 nm de manière à ce que moins de 10 % de l'absorption intégrée soit attribuable à $N_s^0$, et ensuite le recuit du diamant développé par dépôt chimique en phase vapeur à une température d'au moins 1 600 °C pour produire ledit diamant obtenu par dépôt chimique en phase vapeur fourni par l'étape (i) du procédé.

6. Procédé selon les revendications précédentes moyennant quoi la durée de recuit est choisie pour atteindre un stade moyennant quoi tout recuit ultérieur à la même température conduit à moins de 10 % de changement de la concentration des centres NV.

7. Procédé selon une quelconque revendication précédente, dans lequel le diamant fourni avant l'irradiation a les caractéristiques d'absorption suivantes mesurées à température ambiante :

| Désignation | Début (nm) | Fin (nm) | Pic (nm) | Coefficient d'absorption au pic (cm$^{-1}$) |
|---|---|---|---|---|
| 270 nm $N_s^0$ | 220 | 325 | 270 | < 4 |
| Bande à 350 nm Partie de « X » | 270 | 450 | $350 \pm 10$ | < 0,7 |
| Bande à 510 nm Partie de « X » | 420 | 640 | $510 \pm 50$ | < 0,3 |

8. Procédé selon une quelconque revendication précédente, dans lequel au moins 50 % du diamant fourni obtenu par dépôt chimique en phase vapeur a été formé à partir d'un seul secteur de croissance.

9. Procédé selon une quelconque revendication précédente, dans lequel le diamant fourni obtenu par dépôt chimique en phase vapeur à l'étape (i) a une concentration en bore [B] qui est inférieure à $5 \times 10^{15}$ cm$^{-3}$.

10. Procédé selon une quelconque revendication précédente dans lequel le diamant fourni obtenu par dépôt chimique en phase vapeur à l'étape (i) du procédé fait partie d'un plus grand morceau de diamant.

11. Procédé selon une quelconque revendication précédente, dans lequel l'étape d'irradiation du diamant fourni obtenu par dépôt chimique en phase vapeur est réalisée en utilisant un faisceau électronique.

12. Diamant monocristallin synthétique obtenu par dépôt chimique en phase vapeur qui a la caractéristique d'absorption suivante mesurée à température ambiante :

| Caractéristique | Limite | Commentaire expérimental |
|---|---|---|
| 3 107 cm$^{-1}$ | Absente ou $\leq 0,1$ cm$^{-1}$ | Mesurée par FTIR à température ambiante à une résolution du nombre d'onde de 1 cm$^{-1}$ |

et qui a une couleur qui est classée rose pâle spécial lorsqu'il est sous la forme d'un RBC de 0,5 ct et caractérisé comme suit pour un RBC de 0,5 ct équivalent :

| Caractéristique | Plage |
|---|---|
| Angle de teinte $\alpha$ | 0°-60° |
| C* | 3,0-20 |
| L* | > 70 |

13. Diamant monocristallin synthétique obtenu par dépôt chimique en phase vapeur selon la revendication 12, ayant les caractéristiques suivantes :

| $[V^0]$ GR1 | < 0,3 ppm |
|---|---|
| $[V^-]$ ND1 | < 0,3 ppm |
| $[N_s^0]$ | < 0,5 ppm |
| Concentration maximale [V mm chaînes] | < 20 cm$^{-1}$ à 250 |

14. Diamant monocristallin synthétique obtenu par dépôt chimique en phase vapeur selon la revendication 12, ayant les caractéristiques suivantes :

| $[V^0]$ GR1 | < 0,3 ppm |
|---|---|
| $[V^-]$ ND1 | < 0,3 ppm |
| $[N_s^0]$ | < 0,5 ppm |
| [NV] | $\geq 10^{12}$ cm$^{-3}$ |

15. Diamant monocristallin synthétique obtenu par dépôt chimique en phase vapeur selon la revendication 14, ayant une absorption $V_{chaîne}$ à 250 nm qui est inférieure à 20 cm$^1$.

16. Diamant monocristallin synthétique obtenu par dépôt chimique en phase vapeur selon la revendication 14 ou la revendication 15, ayant une valeur T2 qui est supérieure à 100 $\mu$s.

17. Diamant monocristallin synthétique obtenu par dépôt chimique en phase vapeur selon l'une quelconque des revendications 12 à 16, dans lequel le rapport $([NV] + [NV^0]) / [N_s^0]$ est supérieur à 0,16.

18. Diamant monocristallin synthétique obtenu par dépôt chimique en phase vapeur selon l'une quelconque des revendications 12, 13 ou 17, contenant au moins $10^7$ cm$^{-3}$ centres NV$^-$.

19. Diamant monocristallin synthétique obtenu par dépôt chimique en phase vapeur selon l'une quelconque des revendications 12 à 16 contenant au plus $10^{13}$ cm$^{-3}$ centres NV$^-$.

20. Diamant monocristallin synthétique obtenu par dépôt chimique en phase vapeur selon l'une quelconque des revendications 12 à 17 contenant au moins 9 x $10^{15}$ cm$^{-3}$ centres NV$_T$.

21. Diamant monocristallin synthétique obtenu par dépôt chimique en phase vapeur selon l'une quelconque des revendications 12 à 18, ou la revendication 21, contenant au plus $10^{18}$ cm$^{-3}$ centres NV$_T$.

Figure 1

**Route C** | Traditional CVD growth process (or added oxygen CVD process) which results in diamond material having an absorption spectrum with a total integrated absorption in the visible range such that < 10% of the integrated absorption is attributable to $N_s^0$(brown)

Selected CVD grown precursor diamond material

High T anneal

**Routes B and C**

**Routes B and C**

**Route B**

added oxygen CVD grown precursor diamond material

**Route B**

direct use
**Route A**

Provided CVD diamond material

irradiate

irradiated CVD diamond material

NV forming anneal

Treated CVD diamond material

Added oxygen CVD growth process which results in diamond material having an absorption spectrum with a total integrated absorption in the visible range such that at least 10% of the integrated absorption is attributable to $N_s^0$) (colourless, near colourless or yellow)

Figure 2

Figure 3

Figure 4

EP 2 446 069 B1

Figure 5

Figure 6a

Figure 6b

Figure 6c

Figure 6d

Figure 7

EP 2 446 069 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0615954 A
- EP 0316856 A
- US 20040175499 A, Twitchen
- GB 2430194 A
- US 20070053823 A, Viktos Vins
- US 20100028556 A, Apollo
- WO 2007009037 A, Apollo
- WO 2010010352 A
- WO 2010010344 A
- EP 615954 A
- EP 0615954 A1
- WO 03052177 A
- GB 0922449 A
- US 61289282 B
- WO 2004022821 A

**Non-patent literature cited in the description**

- **KING et al.** *Gems & Gemology,* 1994, vol. 30 (4), 220-242
- **JOHN WALKER.** Optical Absorption and Luminescence. *Reports on Progress in Physics,* 1979, vol. 42
- The refractive index was determined according to Peter's equation [(1923) Z. *Phys.,* vol. 15, 358-368
- **J. A. NELDER ; R. MEAD.** *The Computer Journal,* 1965, vol. 7, 308
- **D.F. HOWARTH ; J.A. WEIL ; Z. ZIMPEL.** *J. Magn. Res.,* 2003, vol. 161, 215
- **J.S. HYDE ; M. PASENKIEWICZ-GIERULA ; A. JESMANOWICZ ; W.E. ANTHOLINE.** *Appl. Magn. Reson,* 1990, vol. 1, 483
- **G. DAVIES.** *Physica B,* 1999, vol. 273-274, 15-23
- **VERENA PAGEL-THEISEN.** Diamond grading ABC The Manual. Rubin & Son, 2001, 67
- *Colorimetry,* 1986